(19) Europäisches Patentamt
European Patent Office
Office européen des brevets

(11) **EP 3 881 084 B1**

(12) **EUROPÄISCHE PATENTSCHRIFT**

(45) Veröffentlichungstag und Bekanntmachung des Hinweises auf die Patenterteilung:
**17.06.2026 Patentblatt 2026/25**

(21) Anmeldenummer: **19805572.5**

(22) Anmeldetag: **12.11.2019**

(51) Internationale Patentklassifikation (IPC):
***G01Q 20/04*** *(2010.01)*

(52) Gemeinsame Patentklassifikation (CPC):
**G01Q 20/04**

(86) Internationale Anmeldenummer:
**PCT/EP2019/080932**

(87) Internationale Veröffentlichungsnummer:
**WO 2020/099357 (22.05.2020 Gazette 2020/21)**

(54) **VERFAHREN UND STEUERUNGSEINHEIT ZUR DEMODULATION**

METHOD AND DRIVING UNIT FOR DEMODULATION

MÉTHODE ET UNITÉ D'ACTIONNEMENT POUR LA DÉMODULATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.11.2018 AT 509932018**

(43) Veröffentlichungstag der Anmeldung:
**22.09.2021 Patentblatt 2021/38**

(73) Patentinhaber: **Technische Universität Wien**
**1040 Wien (AT)**

(72) Erfinder:
• **KOHL, Dominik**
**2120 Wolkersdorf (AT)**
• **POIK, Mathias**
**1060 Wien (AT)**
• **SCHITTER, Georg**
**1230 Wien (AT)**

(74) Vertreter: **KLIMENT & HENHAPEL**
**Patentanwälte OG**
**Gonzagagasse 15/2**
**1010 Wien (AT)**

(56) Entgegenhaltungen:
**US-A- 5 742 377  US-A1- 2008 216 583**

• **MARTIN FISCHENEDER ET AL: "Tuneable Q-Factor of MEMS Cantilevers with Integrated Piezoelectric Thin Films", SENSORS, vol. 18, no. 11, 9 November 2018 (2018-11-09), pages 3842, XP055666039, DOI: 10.3390/s18113842**

**Beschreibung**

GEBIET DER ERFINDUNG

Anspruch 1 der vorliegenden Erfindung betrifft ein Verfahren zur Demodulation umfassend die folgenden Schritte:

- Anregen eines schwingfähig gelagerten, zumindest abschnittsweise balkenförmig ausgebildeten Schwingelements zum Schwingen im Bereich einer Resonanzfrequenz des Schwingelements, wobei zum Anregen ein zeitlich variierendes, insbesondere periodisches, Anregungssignal verwendet wird und wobei zumindest die zeitliche Variation des Anregungssignals ($u_{act}$) bekannt ist oder bestimmt wird;
- Detektieren einer modulierten Schwingung des Schwingelements mittels mindestens eines Sensors, wobei der Sensor eine Sensormessgröße liefert, die als Funktion einer Amplitude und einer Phase der modulierten Schwingung des Schwingelements zeitlich variiert;
- Generieren eines ersten Vergleichssignals durch Amplitudenmodulation eines bekannten zeitlich variierenden, insbesondere periodischen, Demodulationssignals mittels der zeitlich variierenden Sensormessgröße,

  wobei der mindestens eine Sensor ein piezoresistives Element umfasst und die Sensormessgröße der elektrische Widerstand des piezoresistiven Elements ist,

  wobei das Demodulationssignal ein Wechselspannungssignal ist und wobei das erste Vergleichssignal mittels eines Spannungsteilers generiert wird, wobei der Spannungsteiler aus einem ersten elektrischen Widerstand und einem zweiten elektrischen Widerstand gebildet ist und wobei der zweite elektrische Widerstand den elektrischen Widerstand des piezoresistiven Elements umfasst.

Weiters betrifft Anspruch 11 der vorliegenden Erfindung eine Steuerungseinheit zur Demodulation, wobei die Steuerungseinheit mit mindestens einem Anregemittel für die Anregung eines schwingfähig gelagerten, zumindest abschnittsweise balkenförmig ausgebildeten Schwingelements zum Schwingen verbindbar ist, wobei die Steuerungseinheit mit mindestens zwei Sensoren zur Detektion einer modulierten Schwingung des Schwingelements verbindbar ist.

STAND DER TECHNIK

In vielen Gebieten der Technik, insbesondere Messtechnik, werden Schwingelemente, die insbesondere zumindest abschnittsweise balkenförmig ausgebildet sind, zum Schwingen im Bereich einer Resonanzfrequenz des jeweiligen Schwingelements angeregt. Die Schwingungen des Schwingelements werden im Allgemeinen durch Wechselwirkungen des Schwingelements mit seiner Umgebung, in der sich ein zu untersuchendes Objekt befinden kann, moduliert. Um Rückschlüsse auf die Umgebung bzw. das zu untersuchende Objekt ziehen zu können, werden sodann Amplitude und/oder Phase der modulierten Schwingung bestimmt, was üblicherweise mit einem hohen technischen und finanziellen Aufwand verbunden ist, beispielsweise mit dem Einsatz von Lock-In-Verstärkern mit einer hohen Bandbreite.

Ein Beispiel für diese Messtechnik ist die Rasterkraftmikroskopie, die zur Analyse von Oberflächen mit Auflösungen im Subnanometerbereich eingesetzt wird. Dabei wird die zu untersuchende Oberfläche von einem als (Mikro-) Cantilever ausgebildeten Schwingelement abgetastet. Zur Oberflächenanalyse werden unterschiedliche Betriebsmodi eingesetzt. Bei Amplituden-modulierter Rasterkraftmikroskopie (AM-AFM) wird der Cantilever zur Oszillation angeregt und die Änderung der Schwingungsamplitude durch Interaktionskräfte mit der Oberfläche gemessen und geregelt. Eine Möglichkeit zur Messung der Verformung bzw. Schwingung des Cantilevers ist die Verwendung von piezoresistiven Sensoren. Die piezoresistiven Sensoren können auf dem Cantilever integriert sein, wobei man in diesem Fall auch von einem piezoresistiven Cantilever spricht. Die Verformung des Cantilevers führt zu einer Änderung des elektrischen Widerstands der piezoresistiven Sensoren. Der piezoresistive Cantilever wird typischerweise in einer Brückenschaltung verschaltet. Die Widerstandsänderung führt daher zu einer zur Verformung des Cantilevers proportionalen Differenzspannung an der Brücke, welche Differenzspannung typischerweise mittels eines Operationsverstärkers verstärkt wird.

Um die Schwingungsamplitude zu bestimmen, wird gemäß dem Stand der Technik die Differenzspannung mittels Lock-In-Verstärker demoduliert. Lock-In-Verstärker, die eine rauscharme Demodulation bei der benötigten hohen Bandbreite erreichen, sind jedoch aufwendig und teuer.

Andere bekannte Demodulationstechniken, die weniger komplex sind, weisen gravierende Nachteile auf, da sie zum einen sehr stark durch Rauschen beeinflusst werden und zum andern bei vorhandenen weiteren Frequenzkomponenten des Cantilevers sehr empfindlich auf diese reagieren, vgl. z.B. M.G. Ruppert et al., "A review of demodulation techniques for amplitude-modulation atomic force microscopy" in Beilstein Journal of Nanotechnology, Vol. 8, No. 1, pp. 1407-1426, 2017.

In Fischeneder M. et al., "Tuneable Q-Factor of MEMS Cantilevers with Integrated Piezoelectric Thin Films", Sensors 18, 3842 (2018), wird ein am Cantilever integriertes piezoelektrisches Element beschrieben, welches eine der Schwingung proportionale Wechselspannung generiert. Durch die additive Überlagerung einer Wechselspannung der gleichen Frequenz wird in weiterer Folge die Schwingung manipuliert. Da bei der additiven Überlagerung jedoch keine Modulation bzw. Demodulation - d.h. eine Multiplikation eines der Schwingung proportionalen Signals mit einem weiteren Signal oder mit anderen Worten eine stets multiplikativ wirkende Amplitudenmodulation - stattfindet, können Amplitude und/oder Phase der Schwingung mit dieser Methode nicht bestimmt werden.

In US 7462270 B2 wird beschrieben, dass ein Sensorelement an einem Cantilever in einer Brückenschaltung verschalten werden kann, welche an der Resonanzfrequenz des Cantilevers betrieben werden kann. Ob oder gar wie die Schwingung des Cantilevers demoduliert werden kann, wird nicht offenbart, ebensowenig wie die Schwingung des Cantilevers erzeugt wird.

In Caruso L. et al., "In Vivo Magnetic Recording of Neuronal Activity", Neuron 95, 1283 (2017), wird ein GMR-Sensor zur Messung magnetischer Felder beschrieben, welcher zur Verbesserung der Messqualität amplitudenmoduliert betrieben wird. Dieser Sensor ist jedoch nicht auf einem zum Schwingen angeregten Schwingelement angebracht, und wird in dieser Veröffentlichung auch keinerlei Bezug auf das Anregen mechanischer Schwingungen genommen.

Aus der US 2008/216583 A1 die Detektion einer Bewegung eines Resonators, beispielsweise eines Cantilever, mittels eines piezoresistiven Elements bekannt. Mittels einer AC-Quelle wird der Resonator zum Schwingen im Bereich seiner Resonanz über einen Piezoaktuator angeregt, wobei das Anregungssignal mit einer Frequenz $\omega_d$ bekannt ist. In Serie mit der Vorrichtung bzw. dem piezoresistiven Element ist ein Widerstand geschaltet. Eine weitere AC-Quelle ist mit dem piezoresistiven Element sowie mit dem Widerstand verbunden, wobei die Wechselspannung über einen 180°-Splitter angelegt ist und eine Frequenz $\omega_b \neq \omega_d$ aufweist. Die von der weiteren AC-Quelle gelieferte Wechselspannung wird durch das piezoresistive Element amplitudenmoduliert.

Aus der US 5742377 A ist ein Cantilever für ein Rasterkraftmikroskop mit integriertem piezoelektrischen Aktuator und integriertem piezoelektrischen Widerstand bekannt. Der piezoelektrische Widerstand ist in einer Wheatstone-Brücke verschaltet, die wie üblich mit einer Gleichspannung als Versorgungsspannung arbeitet.

AUFGABE DER ERFINDUNG

Es ist daher Aufgabe der vorliegenden Erfindung, ein Verfahren sowie Mittel zur Demodulation zur Verfügung zu stellen, die die oben genannten Nachteile vermeiden und insbesondere bei einer zuverlässigen Demodulation technisch einfacher und vor allem kostengünstiger als bekannte Lösungen sind.

DARSTELLUNG DER ERFINDUNG

Die genannte Aufgabenstellung wird bei einem Verfahren gemäß dem Oberbegriff des Anspruchs 1 erfindungsgemäß gelöst durch die kennzeichnenden Merkmale des Anspruchs 1.

Zur Lösung der genannten Aufgabe ist es bei einem Verfahren zur Demodulation gemäß Anspruch 1 umfassend die folgenden Schritte:

- Anregen eines schwingfähig gelagerten, zumindest abschnittsweise balkenförmig ausgebildeten Schwingelements zum Schwingen im Bereich einer Resonanzfrequenz des Schwingelements, wobei zum Anregen ein zeitlich variierendes, insbesondere periodisches, Anregungssignal verwendet wird und wobei zumindest die zeitliche Variation des Anregungssignals bekannt ist oder bestimmt wird;
- Detektieren einer modulierten Schwingung des Schwingelements mittels mindestens eines Sensors, wobei der Sensor eine Sensormessgröße liefert, die als Funktion einer Amplitude und einer Phase der modulierten Schwingung des Schwingelements zeitlich variiert;
- Generieren eines ersten Vergleichssignals durch Amplitudenmodulation eines bekannten zeitlich variierenden, insbesondere periodischen, Demodulationssignals mittels der zeitlich variierenden Sensormessgröße,

  wobei der mindestens eine Sensor ein piezoresistives Element umfasst und die Sensormessgröße der elektrische Widerstand des piezoresistiven Elements ist,
  wobei das Demodulationssignal ein Wechselspannungssignal ist und wobei das erste Vergleichssignal mittels eines Spannungsteilers generiert wird, wobei der Spannungsteiler aus einem ersten elektrischen Widerstand und einem zweiten elektrischen Widerstand gebildet ist und wobei der zweite elektrische Widerstand den elektrischen Widerstand des piezoresistiven Elements umfasst,
  wobei
  ein Differenzsignals durch eine lineare Kombination des ersten Vergleichssignals mit einem bekannten zeitlich variierenden, insbesondere periodischen, zweiten Vergleichssignal generiert wird,
  dass das Differenzsignal mittels mindestens eines als Tiefpassfilter wirkenden Elements gefiltert und so ein gefiltertes Differenzsignal erzeugt wird,

dass das zweite Vergleichssignal mittels des Demodulationssignals erzeugt wird, insbesondere indem das zweite Vergleichssignal als lineare Funktion des Demodulationssignals erzeugt wird,

dass das zweite Vergleichssignal mittels eines weiteren Spannungsteilers generiert wird, der aus einem dritten elektrischen Widerstand und einem vierten elektrischen Widerstand gebildet ist,

wobei der Spannungsteiler und der weitere Spannungsteiler vorzugsweise Teil einer Brückenschaltung sind,

und dass das erste Vergleichssignal und das zweite Vergleichssignal voneinander abgezogen werden, um das Differenzsignal zu generieren,

dadurch gekennzeichnet, dass die modulierte Schwingung des Schwingelements weiters mit einem zweiten Sensor, umfassend ein mit dem piezoresistiven Element im Wesentlichen identisches zweites piezoresistives Element, detektiert wird, wobei der zweite Sensor ebenfalls eine Sensormessgröße liefert, die als Funktion der Amplitude und der Phase der modulierten Schwingung des Schwingelements zeitlich variiert und wobei die Sensormessgröße des zweiten Sensors der elektrische Widerstand des zweiten piezoresistiven Elements ist,

dass ein erstes phasenverschobenes Vergleichssignal generiert wird durch Amplitudenmodulation eines bekannten zeitlich variierenden, insbesondere periodischen, phasenverschobenen Demodulationssignals mittels der zeitlich variierenden Sensormessgröße des zweiten Sensors, wobei das phasenverschobene Demodulationssignal eine definierte bekannte Phasenverschiebung zum Demodulationssignal aufweist,

dass das phasenverschobene Demodulationssignal ebenfalls ein Wechselspannungssignal ist, wobei das erste phasenverschobene Vergleichssignal ebenfalls mittels eines Spannungsteilers generiert wird, wobei der Spannungsteiler aus einem ersten elektrischen Widerstand und einem zweiten elektrischen Widerstand gebildet ist und wobei der zweite elektrische Widerstand den elektrischen Widerstand des zweiten piezoresistiven Elements umfasst,

dass ein phasenverschobenes Differenzsignals durch eine lineare Kombination des ersten phasenverschobenen Vergleichssignals mit einem bekannten zeitlich variierenden, insbesondere periodischen, zweiten phasenverschobenen Vergleichssignal generiert wird,

dass das zweite phasenverschobene Vergleichssignal mittels des phasenverschobenen Demodulationssignals erzeugt wird, wobei das zweite Vergleichssignal mittels eines weiteren Spannungsteilers generiert wird, der aus einem dritten elektrischen Widerstand und einem vierten elektrischen Widerstand gebildet ist, wobei der Spannungsteiler und der weitere Spannungsteiler Teil einer Brückenschaltung sind, und wobei das erste phasenverschobene Vergleichssignal und das zweite phasenverschobene Vergleichssignal voneinander abgezogen werden, um das phasenverschobene Differenzsignal zu generieren,

dass das phasenverschobene Differenzsignal mittels mindestens eines als Tiefpassfilter wirkenden Elements gefiltert und so ein gefiltertes phasenverschobenes Differenzsignal erzeugt wird.

Wie weiter unten noch näher ausgeführt wird, ist das erste Vergleichssignal, das durch die oben genannte Kombination des Demodulationssignals mit der Sensormessgröße erzeugt wird, genauer der Gleichanteil des ersten Vergleichssignals, proportional zur Amplitude der modulierten Schwingung bzw. direkt abhängig von der Phase der modulierten Schwingung. D.h. das erste Vergleichssignal liefert die gewünschte Information über die Amplitude oder Phase der modulierten Schwingung, wobei für viele Anwendungsfälle bereits die Information über das Verhältnis (statt über den exakten numerischen Wert) der zeitlich variierenden Amplitude der modulierten Schwingung ausreicht.

Demoduliert wird die modulierte Schwingung des Schwingelements, wobei besagte Modulation typischerweise durch die Wechselwirkung des Schwingelements mit seiner Umgebung, insbesondere mit mindestens einem in der Umgebung angeordneten Objekt, das untersucht werden soll, zustande kommt. Hieraus ergeben sich unterschiedlichste Anwendungsmöglichkeiten, etwa zur Messung der Dichte des das Schwingelement umgebendenMediums oder zur Messung von Vibrationen des das Schwingelement umgebenden Mediums. D.h. die Anwendungsmöglichkeiten des erfindungsgemäßen Verfahrens gehen weit über die Rasterkraftmikroskopie hinaus.

Ein weiterer Fall, der in diesem Zusammenhang explizit genannt werden soll und auf den weiter unten noch näher eingegangen wird, ist jener, bei dem das Anregungssignal die zu bestimmende Amplitude oder Phase aufweist, wobei die Schwingung des Schwingelements durch das Anregungssignal nicht nur angeregt, sondern auch moduliert wird. Beispielsweise kann hierbei das Anregungssignal ein elektromagnetisches Funksignal sein, von dem lediglich die zeitliche Variation bekannt ist oder bestimmt wird und dessen Amplitude oder Phase ermittelt werden soll. Ein Schwingelement, das durch ein solches Funksignal zum Schwingen angeregt wird, kann beispielsweise ein in an sich bekannter Weise geeignet ausgebildeter Cantilever sein, z.B. indem der Cantilever aus piezoelektrischem Material besteht, welches mit Elektroden versehen ist und daher durch elektrische Signale zum Schwingen angeregt werden kann.

Sofern es sich beim Schwingelement um einen Cantilever eines Rasterkraftmikroskops (AFM) handelt, kommt es aufgrund der Wechselwirkungskräfte, insbesondere der Van-der-Waals-Kräfte, zwischen einer zu untersuchenden Oberfläche und einer Spitze des Cantilevers zu besagter Modulation der Schwingungen des Cantilevers.

"Balkenförmig" ist hier und im Folgenden in der größtmöglichen Allgemeinheit zu verstehen, sodass der zumindest eine balkenförmige Abschnitt des Schwingelements nicht zwangsläufig linear bzw. gerade ausgebildet sein muss. D.h. es wäre z.B. auch ein auch rundes, kreisförmiges oder kreissegmentförmiges Schwingelement abschnittsweise balkenförmig im Sinne der gegenständlichen Anmeldung.

Ebenso ist "schwingfähig gelagert" hier und im Folgenden in der größtmöglichen Allgemeinheit zu verstehen. Hierbei muss das Schwingelement nicht zwangsläufig als Ganzes gegenüber einem weiteren Element beweglich sein. Insbesondere ist es denkbar, dass das Schwingelement abschnittsweise, insbesondere an einem Ende, eingespannt ist im Sinne eines Lagers aus dem Gebiet der Statik. Mit anderen Worten könnte das Schwingelement mit dem weiteren Element abschnittsweise starr verbunden sein. Das Schwingelement, beispielsweise ein Cantilever, kann dann trotzdem mit mindestens einem nicht eingespannten Abschnitt schwingen. Entsprechend kann das schwingfähig gelagerte Schwingelement analog zu einem einseitig eingespannten Balken ausgeführt sein. Die Einspannung kann dabei auch durch eine einstückige Herstellung des Schwingelements (beispielsweise des Cantilevers), mit dem weiteren, im Wesentlichen starren Element bewirkt werden.

Bei den angeregten Schwingungen des Schwingelements kann es sich prinzipiell um beliebige Schwingungen handeln, d.h. es muss nicht zwingend die 1. Harmonische des Schwingelements angeregt werden.

Das Anregungssignal muss nicht zwangsläufig periodisch sein, sondern könnte z.B. lediglich bis auf zufällige Abweichungen periodisch - also "fast periodisch" - sein oder auch aus einem oder mehreren Pulsen mit jeweils einem Spektrum von Frequenzen bestehen oder einen oder mehrere solcher Pulse umfassen. Für manche Anwendungen kann die gezielte Verwendung solcher pulsförmiger Signale vorteilhaft sein, insbesondere wenn das Signal-zu-Rausch-Verhältnis verbessert werden kann, was einen erhöhten Aufwand an Signalaufbereitung und Signalauswertung rechtfertigen kann.

Wenn das Anregungssignal periodisch ist, muss dieses nicht zwangsläufig sinusförmig sein, sondern kann z.B. auch mittels mindestens einer Rechteckschwingung oder Dreieckschwingung ausgebildet sein.

Die modulierte Schwingung des Schwingelements wird mittels eines oder mehrerer Sensoren detektiert. Hierbei kann es sich z.B. um mindestens einen optischen Sensor handeln, der beispielsweise ein Signal eines Lasers detektiert, um Auslenkungen und damit Schwingungen des Schwingelements zu bestimmen, und der als zeitlich variierende Sensormessgröße eine elektrische Größe, insbesondere eine Spannung, aufweist. Ein weiteres Beispiel für einen geeigneten Sensor wäre ein kapazitiver Sensor, der als zeitlich variierende Sensormessgröße primär eine elektrische Kapazität aufweist, um Auslenkungen und damit Schwingungen des Schwingelements bestimmen zu können. Ein weiteres Beispiel für einen geeigneten Sensor wäre ein piezoresistiver Sensor, der als zeitlich variierende Sensormessgröße einen elektrischen Widerstand aufweist, um Auslenkungen und damit Schwingungen des Schwingelements bestimmen zu können.

Für das Demodulationssignal gilt analog das oben zum Anregungssignal Gesagte, d.h. das Demodulationssignal muss nicht zwangsläufig periodisch sein, sondern könnte z.B. lediglich bis auf zufällige Abweichungen periodisch - also "fast periodisch" - sein oder auch aus einem oder mehreren Pulsen mit jeweils einem Spektrum von Frequenzen bestehen oder einen oder mehrere solcher Pulse umfassen. Wenn das Demodulationssignal periodisch gewählt wird, muss dieses nicht zwangsläufig sinusförmig sein, sondern kann z.B. auch mittels mindestens einer Rechteckschwingung oder Dreieckschwingung ausgebildet sein. Entscheidend ist, dass das zeitlich variierende Demodulationssignal bekannt ist.

Insbesondere bietet es sich an, als Demodulationssignal das Anregungssignal oder ein vom Anregungssignal abgeleitetes Signal - z.B. durch Anwendung eines Phasenschubs und/oder Multiplikation des Anregungssignals - zu verwenden. Beispielsweise kann als Demodulationssignal - jeweils bis auf einen allfälligen Phasenschub - genau das Anregungssignal verwendet werden oder ein ganzzahliges Vielfaches (z.B. das Doppelte) des Anregungssignals.

Die modulierte Schwingung des Schwingelements wird durch die Amplitudenmodulation des Demodulationssignals mittels der zeitlich variierenden Sensormessgröße dem ersten Vergleichssignal aufgeprägt.

Das erste Vergleichssignal besteht im Allgemeinen aus einem Gleichanteil und einem zeitlich variierenden Anteil, wobei für beide Anteile die Amplitude der modulierten Schwingung des Schwingelements als Proportionalitätsfaktor aufscheint. D.h. sowohl der Gleichanteil als auch die Amplitude des zeitlich variierenden Anteils des ersten Vergleichssignals sind proportional zur Amplitude der modulierten Schwingung des Schwingelements, wobei die restlichen Faktoren im Allgemeinen bekannt sind und die Amplitude des Anregungssignals umfassen. D.h. indem das erste Vergleichssignal generiert wird, kann im Wesentlichen unmittelbar auf die Amplitude der modulierten Schwingung des Schwingelements geschlossen werden, wobei hierfür unterschiedlichste Möglichkeiten zur geeigneten Weiterverarbeitung des Differenzsignals zur Verfügung stehen.

Der Gleichanteil des ersten Vergleichssignals ist im Allgemeinen eine Funktion der Phase des Demodulationssignals und der Phase der modulierten Schwingung des Schwingelements, insbesondere eine Funktion der Addition und/oder Subtraktion der Phase des Demodulationssignals und der Phase der modulierten Schwingung des Schwingelements. Prinzipiell kann daher zur Bestimmung der Phase der modulierten Schwingung des Schwingelements die Phase des Demodulationssignals geeignet variiert werden.

Vorzugsweise ist nicht nur die zeitliche Variation des Anregungssignals bekannt, sondern auch dessen Amplitude, besonders bevorzugt auch dessen Phase. Ggf. kann mindestens ein weiteres Detektionsmittel bzw. weiterer Sensor zur Bestimmung der zeitlichen Variation und/oder Amplitude und/oder der Phase des Anregungssignals vorgesehen sein.

Wie aus dem weiter oben Gesagten hervorgeht, muss das Anregungssignal jedoch nicht vollständig bekannt sein oder bestimmt werden.

D.h. es sind auch Fälle möglich bei denen vom Anregungssignal lediglich die zeitliche Variation, d.h. wie sich die Amplitude relativ zeitlich ändert, bekannt ist. Typischerweise ist dies beim oben genannten Beispiel eines Funksignals als Anregungssignal der Fall, da üblicherweise zumindest die Frequenz des zu bestimmenden Funksignals bekannt ist. In diesem Fall bietet es sich an, die zeitliche Variation des Demodulationssignals gleich zur zeitlichen Variation des Anregungssignals zu wählen.

Es sind weiters auch Fälle möglich, bei denen die zeitliche Variation des Anregungssignals im Vorhinein nicht bekannt ist, sondern zunächst bestimmt wird. Dies kann beispielsweise mittels des zum Schwingen angeregten Schwingelements selbst geschehen, indem die zeitliche Variation, insbesondere Frequenz, des Demodulationssignal kontinuierlich an die zeitliche Variation, insbesondere Frequenz, des Anregungssignals angepasst wird, wobei auf einen maximalen Gleichanteil des ersten Vergleichssignals geregelt wird. Diese Anpassung bzw. Regelung kann z.B. mittels einer an sich bekannten Phasenregelschleife erfolgen.

Analog zum oben Gesagten ist es bei einer Steuerungseinheit zur Demodulation gemäß Anspruch 11, wobei die Steuerungseinheit mit mindestens einem Anregemittel für die Anregung eines schwingfähig gelagerten, zumindest abschnittsweise balkenförmig ausgebildeten Schwingelements zum Schwingen verbindbar ist, wobei die Steuerungseinheit mit mindestens zwei Sensoren zur Detektion einer modulierten Schwingung des Schwingelements verbindbar ist, erfindungsgemäß vorgesehen, dass die Steuerungseinheit zur Durchführung eines erfindungsgemäßen Verfahrens eingerichtet ist.

Die Verbindung zwischen der Steuerungseinheit und dem mindestens einen Anregemittel und/oder den mindestens zwei Sensoren muss nicht drahtgebunden sein, sondern kann beispielsweise auch funkbasiert sein.

Die Verbindung zwischen der Steuerungseinheit und dem mindestens einen Anregemittel und/oder den mindestens zwei Sensoren ist außerdem nicht zwingend als "direkte" Verbindung zu verstehen, sondern kann auch als "indirekte" Verbindung ausgebildet sein, bei der ein oder mehrere Elemente zwischen der Steuerungseinheit und dem Anregemittel und/oder den mindestens zwei Sensoren geschaltet sind. Insbesondere kann eine solche indirekte Verbindung ein oder mehrere elektronische Bauteile bzw. Schaltungen enthalten. Beispielsweise wäre eine solche indirekte Verbindung zwischen der Steuerungseinheit und dem mindestens einen Sensorelement gegeben, indem der Steuerungseinheit das Differenzsignal oder ein durch Weiterverarbeitung des Differenzsignals erzeugtes Signal zugeführt wird.

Im weiter oben geschilderten Fall, dass das Anregungssignal selbst für die Modulation der Schwingung des Schwingelements ursächlich verantwortlich ist und letztlich die zu bestimmende Amplitude oder Phase aufweist, ist das Anregungssignal das Anregemittel. Über das Schwingelement und den mindestens einen Sensor ist in diesem Fall eine indirekte Verbindung zwischen dem Anregemittel und der Steuerungseinheit herstellbar. Beispielsweise kann das Anregungssignal bzw. das Anregemittel ein (elektromagnetisches) Funksignal sein, dessen Amplitude oder Phase bestimmt werden soll. Das Funksignal regt das Schwingelement zum Schwingen an, und die (modulierte) Schwingung des Schwingelements wird mittels des mindestens einen Sensors detektiert. Durch die Verbindung der Steuerungseinheit mit dem Sensor ist dann jedenfalls auch eine indirekte Verbindung der Steuerungseinheit mit dem Anregemittel bzw. dem Funksignal gegeben.

Außerdem kann die Steuerungseinheit selbstverständlich auch mit weiteren Elementen, d.h. nicht nur mit dem mindestens einen Anregemittel und/oder den mindestens zwei Sensoren, direkt oder indirekt verbunden sein. Erfindungsgemäß wird die Steuerungseinheit bei der Erzeugung des Demodulationssignals und des zweiten Vergleichssignals verwendet. Darüberhinaus wird auch das Anregungssignal der Steuerungseinheit zugeführt bzw. wird die Steuerungseinheit bei der Erzeugung des Anregungssignals verwendet, wobei letzteres eine indirekte Verbindung zwischen Steuerungseinheit und Anregemittel darstellen kann.

Die Steuerungseinheit ist dazu eingerichtet, zumindest die folgenden Schritte durchzuführen bzw. zu steuern:

- Anregen eines schwingfähig gelagerten, zumindest abschnittsweise balkenförmig ausgebildeten Schwingelements zum Schwingen im Bereich einer Resonanzfrequenz des Schwingelements, wobei zum Anregen ein zeitlich variierendes, insbesondere periodisches, Anregungssignal verwendet wird und wobei zumindest die zeitliche Variation des Anregungssignals bekannt ist oder bestimmt wird;;
- Detektieren einer modulierten Schwingung des Schwingelements mittels mindestens eines Sensors, wobei der Sensor eine Sensormessgröße liefert, die als Funktion einer Amplitude und einer Phase der modulierten Schwingung des Schwingelements zeitlich variiert;
- Generieren eines ersten Vergleichssignals durch Amplitudenmodulation eines bekannten zeitlich variierenden, insbesondere periodischen, Demodulationssignals mittels der zeitlich variierenden Sensormessgröße.

Ebenfalls analog zum oben Gesagten ist eine Vorrichtung gemäß Anspruch 12 vorgesehen, die Vorrichtung umfassend die erfindungsgemäße Steuerungseinheit, die Vorrichtung weiters umfassend das mindestens eine Anregemittel, wobei die Steuerungseinheit mit dem mindestens einen Anregemittel verbunden ist, die Vorrichtung weiters umfassend den mindestens einen Sensor, wobei die Steuerungseinheit mit dem mindestens einen Sensor verbunden ist, und die Vorrichtung umfassend das Schwingelement.

Es kommen grundsätzlich unterschiedlichste, an sich bekannte Anregemittel in Frage. Bei einer bevorzugten Ausführungsform der erfindungsgemäßen Vorrichtung ist vorgesehen, dass das mindestens eine Anregemittel einen Piezoaktor umfasst. Dies gewährleistet eine besonders kostengünstige und gleichzeitig sehr genaue Möglichkeit zur Anregung der Schwingungen des Schwingelements.

Alternativ oder zusätzlich sind aber auch andere, an sich bekannte, Anregemittel denkbar, etwa Mittel zur Erzeugung eines Magnetfelds, in dem das Schwingelement angeordnet ist, beispielsweise ein Permanentmagnet oder Helmholtz-Spulen oder eine magnetische Probe, sowie mindestens eine Leiterbahn am Schwingelement, die mit einer hochfrequenten Wechselspannung beaufschlagt wird, sodass es aufgrund des sich ausbildenden hochfrequenten Wechselstroms zum Wirken der Lorentz-Kraft auf das Schwingelement kommt, was wiederum zum Schwingen des Schwingelements führt. Ein weiteres Beispiel für ein Anregemittel wäre eine Magnetisierung des Schwingelements, wobei das Schwingelement durch ein im Bereich des Schwingelements erzeugtes magnetisches Wechselfeld zum Schwingen angeregt wird. Ein weiteres Beispiel für ein Anregemittel wäre die Ausnutzung der elektrostatischen Abstoßung bzw. Anziehung, wobei das Schwingelement und ein, vorzugsweise zu untersuchendes, Objekt, das im Bereich des Schwingelements angeordnet ist, mit elektrischen Wechselspannungen geeignet beaufschlagt werden, um das Schwingen des Schwingelements zu bewirken.

Wie bereits festgehalten, stehen unterschiedliche Möglichkeiten für die Weiterverarbeitung des ersten Vergleichssignals zur Verfügung. Bei einer bevorzugten Ausführungsform des erfindungsgemäßen Verfahrens ist vorgesehen, dass das erste Vergleichssignal mittels mindestens eines als Tiefpassfilter wirkenden Elements gefiltert und so ein gefiltertes erstes Vergleichssignal erzeugt wird. Dies kann beispielsweise mittels eines eigens dafür vorgesehenen Tiefpass-Filterelements erfolgen oder durch andere nachgeschaltete Elemente, die grundsätzlich keine hochfrequenten Signale durchlassen und damit gewissermaßen automatisch als Tiefpassfilter wirken. Beispiele für ein solches nachgeschaltetes Element bei Einsatz des erfindungsgemäßen Verfahrens bei einem Rasterkraftmikroskop wären etwa Signalanpassungselemente, eine Scannersteuerung (auch als Feedback-Regler bezeichnet), ein Scanner, Anti-Aliasing-Filter oder ein Leistungsverstärker.

Im derart gefilterten ersten Vergleichssignal dominiert entsprechend der Gleichanteil, sodass sich die Ermittlung der Amplitude der modulierten Schwingung im Wesentlichen auf eine Division des gefilterten ersten Vergleichssignals durch die bekannten Faktoren - ggf. inkl. der Amplitude des Anregungssignals - beschränkt.

Wie bereits erwähnt, eignet sich das erfindungsgemäße Verfahren zur Anwendung auf Cantilever, insbesondere bei Rasterkraftmikroskopen. Entsprechend ist es bei einer bevorzugten Ausführungsform des erfindungsgemäßen Verfahrens vorgesehen, dass das Schwingelement ein Cantilever, insbesondere ein Cantilever eines Rasterkraftmikroskops, ist. Analog ist es bei einer bevorzugten Ausführungsform der erfindungsgemäßen Vorrichtung vorgesehen, dass das Schwingelement ein Cantilever, insbesondere ein Cantilever eines Rasterkraftmikroskops, ist.

Wie bereits erwähnt, bietet es sich an, als Demodulationssignal das Anregungssignal oder ein vom Anregungssignal abgeleitetes Signal zu verwenden. Dies lässt sich in der Praxis mit besonders geringem Aufwand realisieren. Entsprechend ist es bei einer bevorzugten Ausführungsform des erfindungsgemäßen Verfahrens vorgesehen, dass das Demodulationssignal mittels des Anregungssignals erzeugt wird, insbesondere indem das Demodulationssignal als lineare Funktion des Anregungssignals erzeugt wird.

Beispielsweise kann als Demodulationssignal genau das Anregungssignal verwendet werden oder ein ganzzahliges Vielfaches (z.B. das Doppelte) des Anregungssignals, wobei die Phase des Demodulationssignals, $\Delta\phi$, gegenüber dem Anregungssignal verschoben werden kann. Insbesondere kann die Phase des Demodulationssignals, in vorzugsweise automatisierter Weise, an die Phase der modulierten Schwingung, $\phi_c$, angepasst werden, sodass die Phase des Demodulationssignals und die Phase der modulierten Schwingung beispielsweise gleich sind oder sich lediglich um $\pm\pi/2$ unterscheiden. Hierbei kann analog zu an sich bekannten Phasenanpassungsverfahren bei Amplituden-modulierter Rasterkraftmikroskopie unter Verwendung von Lock-In-Verstärkern vorgegangen werden.

Entsprechend dem oben Gesagten ist es bei einer bevorzugten Ausführungsform des erfindungsgemäßen Verfahrens vorgesehen, dass eine Phase des Demodulationssignal so verschoben wird, dass

$$\Delta\phi \approx \phi_c$$

gilt oder

$$\Delta\phi \approx \phi_c \ \pm \ \pi/2.$$

Sofern $\Delta\phi \approx \phi_c$ realisiert wird, kann die Amplitude der modulierten Schwingung des Schwingelements sehr leicht anhand des Gleichanteils des ersten Vergleichssignals bestimmt werden, da der Gleichanteil in diesem Fall unabhängig von $\Delta\phi$ und $\phi_c$ ist.

Sofern hingegen $\Delta\phi \approx \phi_c \pm \pi/2$ realisiert wird, wird der Gleichanteil des ersten Vergleichssignals im Wesentlichen eliminiert. D.h. indem $\Delta\phi$ solange variiert wird, bis der Gleichanteil des ersten Vergleichssignals verschwindet, kann $\phi_c$ anhand von $\Delta\phi$ bestimmt werden. Letzteres kann z.B. im Hinblick auf einen Phasen-modulierten Betrieb eines Rasterkraftmikroskops (PM-AFM) oder auf einen Frequenz-modulierten Betrieb eines Rasterkraftmikroskops (FM-AFM) ausgenutzt werden.

Konkret ergibt sich durch die Einstellung von $\Delta\phi \approx \phi_c \pm \pi/2$ sofort $\phi_c$ bezogen auf $\pm\pi/2$, was für viele Anwendungsfälle genügt. Darüberhinaus kann $\phi_c$ aber im Prinzip auch exakt bestimmt werden, indem unterschieden wird zwischen den Fällen $\Delta\phi \approx \phi_c + \pi/2$ und $\Delta\phi \approx \phi_c - \pi/2$. Hierzu wird bei der Variation von $\Delta\phi$ das Vorzeichen bzw. die Änderungsrate bei den Nulldurchgängen des Gleichanteils des ersten Vergleichssignals unterschieden: einmal wechselt der Gleichanteil beim Nulldurchgang von positiv auf negativ, einmal von negativ auf positiv.

Wie bereits festgehalten, kommen unterschiedlichste Sensoren und entsprechend unterschiedlichste Sensormessgrößen für das erfindungsgemäße Verfahren in Frage. Es ist vorgesehen, dass der mindestens eine Sensor ein piezoresistives Element umfasst und die Sensormessgröße der elektrische Widerstand des piezoresistiven Elements ist. Analog ist es bei der erfindungsgemäßen Vorrichtung vorgesehen, dass der mindestens eine Sensor ein piezoresistives Element umfasst und die Sensormessgröße der elektrische Widerstand des piezoresistiven Elements ist. Unter elektrischem Widerstand ist dabei nicht notwendigerweise ein rein Ohmscher Widerstand zu verstehen, sondern es kann sich ggf. auch um eine Impedanz handeln. Die Verwirklichung gestaltet sich in der Praxis als relativ einfach, wobei außerdem hohe Messgenauigkeiten erzielt werden.

Um die Widerstandsänderungen des mindestens einen piezoresistiven Elements auf einfache Weise bestimmen zu können, ist es vorgesehen, dass das Demodulationssignal ein Wechselspannungssignal ist und dass das erste Vergleichssignal mittels eines Spannungsteilers generiert wird, wobei der Spannungsteiler aus einem ersten elektrischen Widerstand und einem zweiten elektrischen Widerstand gebildet ist und wobei der zweite elektrische Widerstand den elektrischen Widerstand des piezoresistiven Elements umfasst. Analog ist es bei der erfindungsgemäßen Vorrichtung vorgesehen, dass ein Spannungsteiler vorgesehen ist, um das erste Vergleichssignal zu generieren, wobei der Spannungsteiler aus einem ersten elektrischen Widerstand und einem zweiten elektrischen Widerstand gebildet ist und wobei der zweite elektrische Widerstand den elektrischen Widerstand des piezoresistiven Elements umfasst.

Der zweite elektrische Widerstand variiert somit zeitlich gemäß den zeitlichen Widerstandsänderungen des (mindestens einen) piezoresistiven Elements. Der zweite Widerstand kann dabei aus dem elektrischen Widerstand des (mindestens einen) piezoresistiven Elements bestehen. Der zweite elektrische Widerstand kann aber auch aus einer Summe von elektrischen Widerständen bestehen, die den elektrischen Widerstand des (mindestens einen) piezoresistiven Elements umfasst. Diese Summe kann beispielsweise gebildet sein aus dem elektrischen Widerstand des (mindestens einen) piezoresistiven Elements und einem weiteren elektrischen Widerstand der im Wesentlichen dem ersten elektrischen Widerstand entspricht, sodass das erste Vergleichssignals zeitlich rund um die halbe Amplitude des Demodulationssignals schwankt.

Das Demodulationssignal bzw. Wechselspannungssignal wird an den Spannungsteiler angelegt. Der Spannungsabfall am zweiten Widerstand entspricht dem Demodulationssignal, wobei die Amplitude gemäß der zeitlich variierenden Sensormessgröße, d.h. gemäß den zeitlichen Widerstandsänderungen des piezoresistiven Elements, moduliert ist. Auf diese Weise wird das erste Vergleichssignal erzeugt, welches also als Spannungsabfall am zweiten Widerstand abgegriffen werden kann.

Selbstverständlich entspricht in diesem Fall auch der Spannungsabfall am ersten Widerstand dem Demodulationssignal, wobei die Amplitude gemäß der zeitlich variierenden Sensormessgröße, d.h. durch die zeitlichen Widerstandsänderungen des piezoresistiven Elements, moduliert ist. Diese Modulation ist zwar invers zur Modulation am zweiten Widerstand, stellt aber jedenfalls trotzdem eine Amplitudenmodulation des Demodulationssignals dar. Mit anderen Worten kann auch der Spannungsabfall am ersten Widerstand des Spannungsteilers als erstes Vergleichssignal verwendet werden.

Wie bereits erläutert, umfasst das erste Vergleichssignal einen Gleichanteil und einen zeitlich variierenden Anteil. Es zeigt sich, dass letzterer eine relativ hohe Amplitude haben kann. Möchte man in einem solchen Fall den zeitlich variierenden Anteil mit einem Tiefpassfilter entfernen, muss dieser eine relativ niedrige Grenzfrequenz aufweisen, was sich wiederum auf die Geschwindigkeit des Verfahrens bzw. der Anwendungen des Verfahrens beschränkend auswirkt. Für manche Anwendungen spielt dies praktisch keine Rolle, beispielsweise für die Dichtebestimmung eines das Schwingelement umgebenden Mediums, wobei diese Dichte im Allgemeinen nicht sehr rasch variiert. Bei anderen Anwendungen kann es wünschenswert sein, die Geschwindigkeit zu erhöhen, beispielsweise um in der Rasterkraftmikroskopie besonders hohe Scangeschwindigkeiten zu erreichen.

Um die Amplitude oder die Phase der modulierten Schwingung aus dem ersten Vergleichssignal besser herausarbeiten zu können - insbesondere wenn es auf die zeitliche Auflösung ankommt, also bei Anwendungen die eine rasche Demodulation erfordern -, ist erfindungsgemäß vorgesehen, dass ein Differenzsignals durch eine lineare Kombination des ersten Vergleichssignals mit einem bekannten zeitlich variierenden, insbesondere periodischen, zweiten Vergleichssignal generiert wird.

Für das zweite Vergleichssignal gilt analog das oben zum Anregungssignal bzw. zum Demodulationssignal Gesagte, d.h. das zweite Vergleichssignal muss nicht zwangsläufig periodisch sein, sondern könnte z.B. lediglich bis auf zufällige Abweichungen periodisch - also "fast periodisch" - sein oder auch aus einem oder mehreren Pulsen mit jeweils einem Spektrum von Frequenzen bestehen oder einen oder mehrere solcher Pulse umfassen. Wenn das zweite Vergleichssignal periodisch gewählt wird, muss dieses nicht zwangsläufig sinusförmig sein, sondern kann z.B. auch mittels mindestens einer Rechteckschwingung oder Dreieckschwingung ausgebildet sein. Entscheidend ist, dass das zeitlich variierende zweite Vergleichssignal bekannt ist.

Insbesondere bietet es sich an, als zweites Vergleichssignal das Demodulationssignal oder ein vom Demodulationssignal abgeleitetes Signal - z.B. durch Multiplikation des Demodulationssignals - zu verwenden.

Das Differenzsignal wird durch Linearkombination des ersten Vergleichssignals mit dem zweiten Vergleichssignal, insbesondere durch Subtraktion oder Addition der beiden Signale, gewonnen. Lediglich der Vollständigkeit halber wird festgehalten, dass bei dieser Linearkombination die beiden Vergleichssignale auch mit Koeffizienten ungleich 1 multipliziert werden können. Hier und im Folgenden ist Linearkombination bzw. lineare Kombination so zu verstehen, dass die Addition eines konstanten Terms umfasst sein kann.

Auch das Differenzsignal besteht im Allgemeinen aus einem Gleichanteil und einem zeitlich variierenden Anteil, wobei für beide Anteile die Amplitude der modulierten Schwingung des Schwingelements als Proportionalitätsfaktor aufscheint. D.h. sowohl der Gleichanteil als auch die Amplitude des zeitlich variierenden Anteils des Differenzsignals sind proportional zur Amplitude der modulierten Schwingung des Schwingelements, wobei die restlichen Faktoren im Allgemeinen bekannt sind und ggf. die Amplitude des Anregungssignals umfassen.

Wie beim ersten Vergleichssignal ist der Gleichanteil des Differenzsignals im Allgemeinen eine Funktion der Phase des Demodulationssignals und der Phase der modulierten Schwingung des Schwingelements, insbesondere eine Funktion der Addition und/oder Subtraktion der Phase des Demodulationssignals und der Phase der modulierten Schwingung des Schwingelements. Entsprechend gilt das oben zur Weiterverarbeitung des ersten Vergleichssignals Gesagte analog auch für das Differenzsignal.

Im Gegensatz zum ersten Vergleichssignal kann die Amplitude des zeitlich variierenden Terms des Differenzsignals mittels der Linearkombination der beiden Vergleichssignale stark verkleinert werden. Dies vereinfacht die Weiterverarbeitung des Differenzsignals und begünstigt insbesondere den Einsatz des erfindungsgemäßen Verfahrens bei Anwendungen, die eine sehr rasche Demodulation benötigen. Insbesondere muss in diesem Fall bei Verwendung eines Tiefpassfilters zur Entfernung des zeitlich variierenden Anteils des Differenzsignals der Tiefpassfilter (siehe auch weiter unten) keine relativ niedrige Grenzfrequenz aufweisen. Die raschere Demodulation wirkt sich beispielsweise beim Einsatz des erfindungsgemäßen Verfahrens für Rasterkraftmikroskopie positiv aus, da eine sehr rasche Scannersteuerung und damit eine raschere Untersuchung der Probenoberfläche ermöglicht werden.

Das Differenzsignal kann vollkommen analog zum ersten Vergleichssignal weiterverarbeitet werden. D.h. es stehen unterschiedliche Möglichkeiten für die Weiterverarbeitung des Differenzsignals zur Verfügung. Beim erfindungsgemäßen Verfahren ist vorgesehen, dass das Differenzsignal mittels mindestens eines als Tiefpassfilter wirkenden Elements gefiltert und so ein gefiltertes Differenzsignal erzeugt wird. Dies kann beispielsweise mittels eines eigens dafür vorgesehenen Tiefpass-Filterelements erfolgen oder durch andere nachgeschaltete Elemente, die grundsätzlich keine hochfrequenten Signale durchlassen und damit gewissermaßen automatisch als Tiefpassfilter wirken. Beispiele für ein solches nachgeschaltetes Element bei Einsatz des erfindungsgemäßen Verfahrens bei einem Rasterkraftmikroskop wären etwa Signalanpassungselemente, eine Scannersteuerung (auch als Feedback-Regler bezeichnet), ein Scanner, Anti-Aliasing-Filter, oder ein Leistungsverstärker.

Im derart gefilterten Differenzsignal dominiert entsprechend der Gleichanteil, sodass sich die Ermittlung der Amplitude der modulierten Schwingung im Wesentlichen auf eine Division des gefilterten Differenzsignals durch die bekannten Faktoren - ggf. inkl. der Amplitude des Anregungssignals - beschränkt. Es gilt analog das zum ersten Vergleichssignal oben Gesagte.

Gemäß dem oben Gesagten ist es bei einer bevorzugten Ausführungsform der erfindungsgemäßen Vorrichtung vorgesehen, dass mindestens ein Tiefpassfilter vorgesehen ist. Mit dem mindestens einen Tiefpassfilter kann das erste Vergleichssignal gefiltert und so ein gefiltertes erstes Vergleichssignal erzeugt werden oder wird das Differenzsignal gefiltert und so wird ein gefiltertes Differenzsignal erzeugt.

Wie bereits erwähnt, bietet es sich an, als zweites Vergleichssignal das Demodulationssignal oder ein vom Demodulationssignal abgeleitetes Signal zu verwenden. Dies lässt sich in der Praxis mit besonders geringem Aufwand realisieren. Entsprechend ist es beim erfindungsgemäßen Verfahren vorgesehen, dass das zweite Vergleichssignal mittels des Demodulationssignals erzeugt wird, insbesondere indem das zweite Vergleichssignal als lineare Funktion des Demodulationssignals erzeugt wird. Beispielsweise kann als zweites Vergleichssignal genau das Demodulationssignal verwendet werden oder ein ganzzahliges Vielfaches (z.B. das Doppelte) des Demodulationssignals.

Wie bereits erwähnt, gilt für die Weiterverarbeitung des Differenzsignals analog das oben zum ersten Vergleichssignal Gesagte. D.h. sofern $\Delta\phi \approx \phi_c$ realisiert wird, kann der Gleichanteil des Differenzsignals, wie oben beschrieben, sehr leicht bestimmt werden, womit wiederum eine einfache Bestimmung der Amplitude der modulierten Schwingung des Schwingelements ermöglicht wird, da der Gleichanteil in diesem Fall unabhängig von $\Delta\phi$ und $\phi_c$ ist.

Sofern hingegen $\Delta\phi \approx \phi_c \pm \pi/2$ realisiert wird, wird der Gleichanteil des Differenzsignals im Wesentlichen eliminiert. D.h. indem $\Delta\phi$ solange variiert wird, bis der Gleichanteil des Differenzsignals verschwindet, kann $\phi_c$ anhand von $\Delta\phi$ bestimmt werden. Letzteres kann z.B. im Hinblick auf einen Phasen-modulierten Betrieb eines Rasterkraftmikroskops (PM-AFM) oder auf einen Frequenz-modulierten Betrieb eines Rasterkraftmikroskops (FM-AFM) ausgenutzt werden.

Konkret ergibt sich durch die Einstellung von $\Delta\phi \approx \phi_c \pm \pi/2$ sofort $\phi_c$ bezogen auf $\pm \pi/2$, was für viele Anwendungsfälle genügt. Darüberhinaus kann $\phi_c$ aber im Prinzip auch exakt bestimmt werden, indem unterschieden wird zwischen den Fällen $\Delta\phi \approx \phi_c + \pi/2$ und $\Delta\phi \approx \phi_c - \pi/2$. Hierzu wird bei der Variation von $\Delta\phi$ das Vorzeichen bzw. die Änderungsrate bei den Nulldurchgängen des Gleichanteils des Differenzsignals unterschieden: einmal wechselt der Gleichanteil beim Nulldurchgang von positiv auf negativ, einmal von negativ auf positiv.

Bei Verwendung des Spannungsteilers zur Erzeugung des ersten Vergleichssignals kann als zweites Vergleichssignal das Demodulationssignal bzw. die an den Spannungsteiler angelegte Wechselspannung - oder ein davon, beispielsweise durch Verstärkung oder Multiplikation, abgeleitetes Signal - verwendet werden kann, um einen besonders einfachen Aufbau zu gewährleisten. Entsprechend ist es beim erfindungsgemäßen Verfahren vorgesehen, dass das zweite Vergleichssignal mittels eines weiteren Spannungsteilers generiert wird, der aus einem dritten elektrischen Widerstand und einem vierten elektrischen Widerstand gebildet ist, wobei der Spannungsteiler und der weitere Spannungsteiler vorzugsweise Teil einer Brückenschaltung sind, und dass das erste Vergleichssignal und das zweite Vergleichssignal voneinander abgezogen werden, um das Differenzsignal zu generieren. Analog ist es bei einer besonders bevorzugten Ausführungsform der erfindungsgemäßen Vorrichtung vorgesehen, dass die Vorrichtung einen weiteren Spannungsteiler, der aus einem dritten elektrischen Widerstand und einem vierten elektrischen Widerstand gebildet ist, umfasst, um ein zweites Vergleichssignal mittels des weiteren Spannungsteilers zu generieren, wobei der Spannungsteiler und der weitere Spannungsteiler vorzugsweise Teil einer Brückenschaltung sind.

Der Vollständigkeit halber sei bemerkt, dass das Differenzsignal durch Subtraktion des zweiten Vergleichssignals vom ersten Vergleichssignal gebildet werden kann oder durch Subtraktion des ersten Vergleichssignals vom zweiten Vergleichssignal.

Zur Erzeugung des Differenzsignals bzw. zur Subtraktion der beiden Vergleichssignale voneinander kann z.B. ein Operationsverstärker verwendet werden, dem beide Vergleichssignale zugeführt werden und dessen Ausgangssignal dann das Differenzsignal ist.

Im Falle der Brückenschaltung kann bei der Erzeugung des Differenzsignals die Brückenschaltung, genauer der Brückenzweig der Brückenschaltung, verwendet werden. Dabei ergibt sich das Differenzsignal gewissermaßen automatisch im Brückenzweig. Typischerweise wird ein Operationsverstärker zur Verstärkung des Signals des Brückenzweigs verwendet, wobei der Operationsverstärker insbesondere im Brückenzweig vorgesehen sein kann. Das Differenzsignal ist in diesem Fall als das Ausgangssignal des Operationsverstärkers zu verstehen.

Der dritte elektrische Widerstand und der vierte elektrische Widerstand können im Prinzip beliebig gewählt werden. Insbesondere können der dritte elektrische Widerstand und der vierte elektrische Widerstand gleich wie der erste elektrische Widerstand gewählt werden. Der erste, zweite und dritte elektrische Widerstand sowie ggf. der weitere elektrische Widerstand können dabei auch jeweils als variabler Widerstand ausgeführt sein.

Wie bereits mehrfach erwähnt, eignet sich das erfindungsgemäße Verfahren bzw. die erfindungsgemäße Vorrichtung insbesondere für die Verwendung in einem Rasterkraftmikroskop. Entsprechend ist es bei einer besonders bevorzugten Ausführungsform des erfindungsgemäßen Verfahrens vorgesehen, dass das gefilterte Differenzsignal mit einem konstanten Verstärkungsfaktor verstärkt und anschließend von einem Sollwert abgezogen wird, um ein Kontrollsignal zu bilden, wobei das Kontrollsignal einer Scannersteuerung zugeführt wird, um den Abstand zwischen einer Probe und dem Cantilever zu justieren. Analog ist es bei einer besonders bevorzugten Ausführungsform der erfindungsgemäßen Vorrichtung vorgesehen, dass eine Scannersteuerung vorgesehen ist, um den Abstand zwischen einer Probe und dem Cantilever zu justieren.

Hiermit wird also ein Regelkreis des Rasterkraftmikroskops realisiert. Der Regelkreis versucht die Amplitude der Schwingung des Cantilevers konstant zu halten, indem der Abstand, und somit die Kraftwechselwirkung, zwischen dem Cantilever bzw. der Cantileverspitze und der Probe angepasst wird. Dieser Modus findet insbesondere bei Messungen unter Umgebungsbedingungen oder auch in Flüssigkeiten Verwendung.

Die Scannersteuerung ist vorzugsweise mit der Steuerungseinheit verbunden, wobei die Verbindung nicht drahtgebunden sein muss, sondern beispielsweise auch über Funk realisiert sein kann. Es ist auch denkbar, dass die Scannersteuerung in die Steuerungseinheit integriert ist.

Beim erfindungsgemäßen Verfahren ist vorgesehen, dass die modulierte Schwingung des Schwingelements weiters mit einem zweiten Sensor, umfassend ein mit dem piezoresistiven Element im Wesentlichen identisches zweites piezoresistives Element, detektiert wird, wobei der zweite Sensor ebenfalls eine Sensormessgröße liefert, die als Funktion der Amplitude und der Phase der

modulierten Schwingung des Schwingelements zeitlich variiert und wobei die Sensormessgröße des zweiten Sensors der elektrische Widerstand des zweiten piezoresistiven Elements ist, dass ein erstes phasenverschobenes Vergleichssignal generiert wird durch Amplitudenmodulation eines bekannten zeitlich variierenden, insbesondere periodischen, phasenverschobenen Demodulationssignals mittels der zeitlich variierenden Sensormessgröße des zweiten Sensors, wobei das phasenverschobene Demodulationssignal eine definierte bekannte Phasenverschiebung zum Demodulationssignal aufweist, dass das phasenverschobene Demodulationssignal ebenfalls ein Wechselspannungssignal ist, wobei das erste phasenverschobene Vergleichssignal ebenfalls mittels eines Spannungsteilers generiert wird, wobei der Spannungsteiler aus einem ersten elektrischen Widerstand und einem zweiten elektrischen Widerstand gebildet ist und wobei der zweite elektrische Widerstand den elektrischen Widerstand des zweiten piezoresistiven Elements umfasst, dass ein phasenverschobenes Differenzsignals durch eine lineare Kombination des ersten phasenverschobenen Vergleichssignals mit einem bekannten zeitlich variierenden, insbesondere periodischen, zweiten phasenverschobenen Vergleichssignal generiert wird, dass das zweite phasenverschobene Vergleichssignal mittels des phasenverschobenen Demodulationssignals erzeugt wird, wobei das zweite Vergleichssignal mittels eines weiteren Spannungsteilers generiert wird, der aus einem dritten elektrischen Widerstand und einem vierten elektrischen Widerstand gebildet ist, wobei der Spannungsteiler und der weitere Spannungsteiler Teil einer Brückenschaltung sind, und wobei das erste phasenverschobene Vergleichssignal und das zweite phasenverschobene Vergleichssignal voneinander abgezogen werden, um das phasenverschobene Differenzsignal zu generieren, dass das phasenverschobene Differenzsignal mittels mindestens eines als Tiefpassfilter wirkenden Elements gefiltert und so ein gefiltertes phasenverschobenes Differenzsignal erzeugt wird.

Dies gestattet die gleichzeitige Bestimmung der Amplitude und der Phase der modulierten Schwingung, indem das gefilterte phasenverschobene Differenzsignal und das gefilterte Differenzsignal geeignet mathematisch kombiniert bzw. weiterverarbeitet werden. Die hierbei zugrundeliegende Idee ist es, die zwei voneinander unabhängigen, aber im Wesentlichen gleichen - also bis auf unvermeidbare, vor allem herstellungstechnisch begründete Unterschiede, die jedoch kein anderes elektrisches Verhalten generieren **-,** piezoresistiven Elemente mit bekannten unterschiedlichen Demodulationssignalen auf gleiche Weise zu betreiben, um eine Auswertung analog zum wohlbekannten IQ-Verfahren (vgl. z.B. M.G. Ruppert et al., "A review of demodulation techniques for amplitude-modulation atomic force microscopy" in Beilstein Journal of Nanotechnology, Vol. 8, No. 1, pp. 1407-1426, 2017) vornehmen zu können. Dabei haben die beiden Demodulationssignale, d.h. das Demodulationssignal und das phasenverschobene Demodulationssignal eine fixe, wohlbekannte Phasenlage zueinander, was prinzipiell ausreichend für die anschließende Bestimmung von Amplitude und Phase der modulierten Schwingung ist.

Daher sind beide Demodulationssignale als Wechselspannungssignale ausgebildet, wobei die beiden Wechselspannungen sich zumindest durch den bekannten Phasenschub voneinander unterscheiden. Das derart erzeugte phasenverschobene Demodulationssignal wird wie das Demodulationssignal an eine Brückenschaltung angelegt, um das erste phasenverschobene Vergleichssignal sowie das zweite phasenverschobene Vergleichssignal zu erzeugen. Der elektrische Widerstand des zweiten piezoresistiven Elements ist dabei Teil eines Widerstands eines Spannungsteilers dieser Brückenschaltung. In weiterer Folge werden das erste phasenverschobene Vergleichssignal und das zweite phasenverschobene Vergleichssignal - beispielsweise mittels eines Operationsverstärkers - voneinander abgezogen, um das phasenverschobene Differenzsignal zu erzeugen, welches wiederum mittels eines Tiefpassfilters bzw. mittels eines als Tiefpassfilter wirkenden Elements gefiltert wird, um das gefilterte phasenverschobene Differenzsignal zu erzeugen.

Entsprechend ist es bei der erfindungsgemäßen Vorrichtung vorgesehen, dass ein zweiter Sensor, umfassend ein mit dem piezoresistiven Element im Wesentlichen identisches zweites piezoresistives Element, vorgesehen ist, dessen Sensormessgröße der elektrische Widerstand des zweiten piezoresistiven Elements ist, dass ein Spannungsteiler vorgesehen ist, um das erste phasenverschobene Vergleichssignal zu generieren, wobei der Spannungsteiler aus einem ersten elektrischen Widerstand und einem zweiten elektrischen Widerstand gebildet ist und wobei der zweite elektrische Widerstand den elektrischen Widerstand des zweiten piezoresistiven Elements umfasst, dass ein weiterer Spannungsteiler vorgesehen ist, der aus einem dritten elektrischen Widerstand und einem vierten elektrischen Widerstand gebildet ist, um das zweite phasenverschobene Vergleichssignal mittels des weiteren Spannungsteilers zu generieren, wobei der Spannungsteiler und der weitere Spannungsteiler Teil einer Brückenschaltung sind.

Zur Erzeugung der beiden Wechselspannungen für das Demodulationssignal und das phasenverschobene Demodulationssignal können eine Wechselspannungsquelle sowie Mittel, insbesondere umfassend mindestens eine Spule und/oder mindestens einen Kondensator, zur Erzeugung eines Phasenschubs vorgesehen sein. Bei einer besonders bevorzugten Ausführungsform der erfindungsgemäßen Vorrichtung ist jedoch vorgesehen, dass eine Wechselspannungsquelle vorgesehen ist, um das Demodulationssignal zu generieren, und eine Wechselspannungsquelle, um das phasenverschobene Demodulationssignal zu generieren. Durch die Verwendung von zwei separaten Wechselspannungsquellen können das Demodulationssignal und das phasenverschobene Demodulationssignal jeweils exakt nach gewünschten Vorgaben eingestellt bzw. erzeugt werden.

Bei einer besonders bevorzugten Ausführungsform des erfindungsgemäßen Verfahrens ist vorgesehen, dass die definierte bekannte Phasenverschiebung des phasenverschobenen Demodulationssignals zum Demodulationssignal 90° beträgt. Dies ermöglicht eine besonders einfache Herstellbarkeit entsprechender Demodulationssignale, insbesondere indem das Demodulationssignal als Sinus-Funktion und das phasenverschobene Demodulationssignal als Cosinus-Funktion gewählt wird.

Es wäre dabei natürlich denkbar, dass sich das phasenverschobene Demodulationssignal vom Demodulationssignal neben dem bekannten Phasenschub auch um einen fixen bekannten Faktor unterscheidet, der rechnerisch im Weiteren leicht berücksichtigt werden kann, um Amplitude und Phase der modulierten Schwingung zu bestimmen. Um jedoch eine besonders einfache Bestimmung zu ermöglichen, ist es bei einer besonders bevorzugten Ausführungsform des erfindungsgemäßen Verfahrens vorgesehen, dass das phasenverschobene Demodulationssignal mit dem Demodulationssignal bis auf die definierte bekannte Phasenverschiebung ident ist.

Bei einer besonders bevorzugten Ausführungsform des erfindungsgemäßen Verfahrens ist vorgesehen, dass das gefilterte Differenzsignal und das gefilterte phasenverschobene Differenzsignal mittels einer Signalverarbeitungseinheit verarbeitet werden, um eine Ausgabeamplitude und/oder eine Ausgabephase zu berechnen. Die Ausgabeamplitude bzw. Ausgabephase kann, muss aber nicht exakt der Amplitude bzw. Phase der modulierten Schwingung entsprechen. Je nach Anwendung kann es notwendig sein, den exakten Wert der Amplitude bzw. Phase der modulierten Schwingung zu bestimmen, oder es kann ausreichend sein, den entsprechenden Wert z.B. bis auf einen konstanten Faktor zu bestimmen. Die Signalverarbeitungseinheit kann die konkret gewünschte Berechnung durchführen, wobei die Signalverarbeitungseinheit vorzugsweise programmierbar ist, um die Berechnung an unterschiedliche Anforderungen anpassen zu können.

Entsprechend ist es bei der erfindungsgemäßen Vorrichtung vorgesehen, dass Mittel zur Erzeugung des Differenzsignals und des phasenverschobenen Differenzsignals vorgesehen sind, dass ein Tiefpassfilter vorgesehen ist, um durch Filterung des Differenzsignal das gefilterte Differenzsignal zu erzeugen, und ein Tiefpassfilter, um durch Filterung des phasenverschobenen Differenzsignals das gefilterte phasenverschobene Differenzsignal zu erzeugen, und dass eine Signalverarbeitungseinheit vorgesehen ist, um das gefilterte Differenzsignal und das gefilterte phasenverschobene Differenzsignal zu verarbeiten und eine Ausgabeamplitude und/oder eine Ausgabephase zu berechnen.

Eine besonders einfache Berechnung der Ausgabeamplitude bzw. Ausgabephase ergibt sich, wenn sich das Demodulationssignal und das phasenverschobene Demodulationssignal nur durch den Phasenschub unterscheiden und als Sinus- und Cosinussignal ausgebildet sind. Für diesen Fall ist es bei einer besonders bevorzugten Ausführungsform des erfindungsgemäßen Verfahrens vorgesehen, dass die Ausgabeamplitude berechnet wird gemäß

$$\mathrm{A_{out}} = (\ (\mathrm{DIFFS\_f})^2 + (\mathrm{DIFFS\_Q\_f})^2\ )^{1/2}$$

und/oder die Ausgabephase gemäß

$$\phi_{\mathrm{out}} = \mathrm{atan}(\ \mathrm{DIFFS\_Q\_f} / \mathrm{DIFFS\_f}\ ),$$

wobei $A_{out}$ die Ausgabeamplitude bezeichnet, DIFFS_f das gefilterte Differenzsignal, DIFFS_Q_f das gefilterte phasenverschobene Differenzsignal, $\phi_{out}$ die Ausgabephase und atan den Arkustangens.

Typischerweise ergibt sich hierbei, dass die Ausgabephase identisch zur Phase der modulierten Schwingung ist und die Ausgabeamplitude bis auf zumindest einen bekannten konstanten Faktor identisch zur Amplitude der modulierten Schwingung. Analog zum weiter oben Gesagten ist es denkbar, dass die Steuerungseinheit bei der Erzeugung des phasenverschobenen Demodulationssignals bzw. des ersten und zweiten phasenverschobenen Vergleichssignals und/oder des phasenverschobenen Differenzsignals und/oder des gefilterten phasenverschobenen Differenzsignals verwendet wird. Weiters kann die Signalverarbeitungseinheit in die Steuerungseinheit integriert sein.

KURZE BESCHREIBUNG DER FIGUREN

Die Erfindung wird nun anhand von Ausführungsbeispielen näher erläutert. Die Zeichnungen sind beispielhaft und sollen den Erfindungsgedanken zwar darlegen, ihn aber keinesfalls einengen oder gar abschließend wiedergeben.

Dabei zeigt:

Fig. 1    ein Blockschaltbild eines bekannten Verfahrens einer Amplituden-modulierten Rasterkraftmikroskopie (AM-AFM)

Fig. 2    ein Blockschaltbild der Verwendung zweier möglicher Beispiele eines Verfahrens für AM-AFM, die nicht Teil der Erfindung sind

Fig. 3    ein Blockschaltbild eines vereinfachten Aufbaus zur Durchführung eines weiteren Beispiels des Verfahrens, das nicht Teil der Erfindung ist

Fig. 4   ein Blockschaltbild eines weiteren vereinfachten Aufbaus zur Durchführung eines weiteren Beispiels des Verfahrens, das nicht Teil der Erfindung ist

Fig. 5   ein Blockschaltbild eines minimalen Aufbaus zur Durchführung eines weiteren Beispiels des Verfahrens, das nicht Teil der Erfindung ist

Fig. 6   ein Blockschaltbild eines Aufbaus zur Durchführung des erfindungsgemäßen Verfahrens

WEGE ZUR AUSFÜHRUNG DER ERFINDUNG

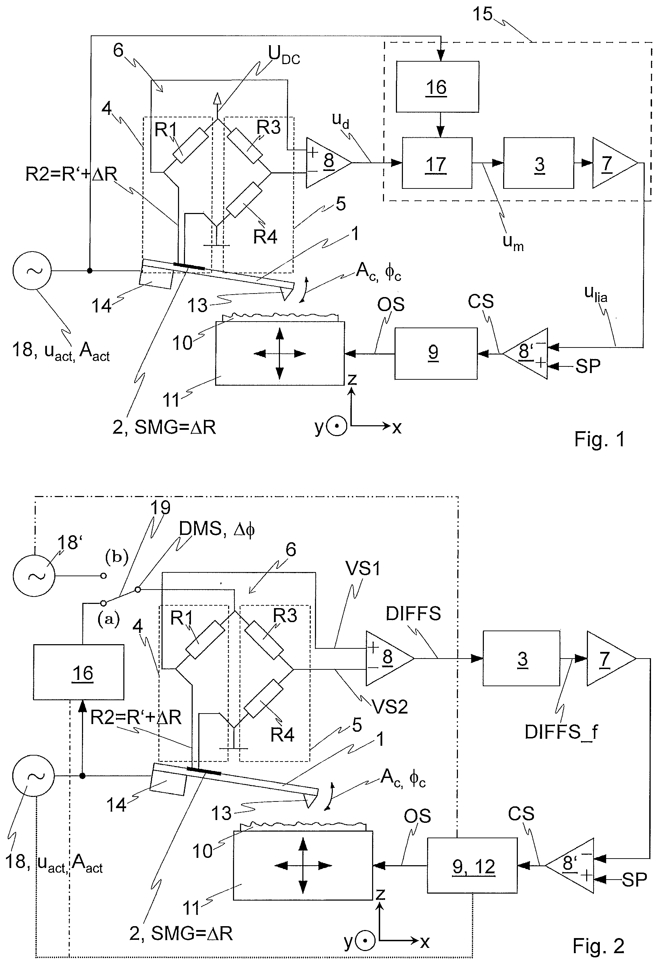

Fig. 1 zeigt ein Blockschaltbild einer Amplituden-modulierten Rasterkraftmikroskopie (AM-AFM), bei der zur Demodulation einer modulierten Schwingung eines Schwingelements in Form eines Cantilevers 1 ein Verfahren gemäß dem Stand der Technik Verwendung findet. Der Cantilever 1 weist eine Cantileverspitze 13 auf, um die Topographie einer Probe 10 mit hoher Auflösung bestimmen zu können. Die Probe 10 ist hierzu auf einem Scanner 11 platziert, der die Probe 10 parallel zu drei wechselseitig normal aufeinander stehenden Raumrichtungen x, y, z verschieben kann, wobei die zwei Doppelpfeile Verschiebungen in der Zeichenebene der Fig. 1, d.h. parallel zur x- und z-Richtung, andeuten.

Der Cantilever 1 ist auf einem Piezoaktor 14 befestigt, mit dem der Cantilever 1 in Schwingungen mit einer Frequenz f im Bereich einer Resonanzfrequenz des Cantilevers 1 versetzt werden kann, d.h. der Cantilever 1 ist am Piezoaktor 14 schwingfähig gelagert. Zum Anregen wird dabei ein bekanntes zeitlich variierendes Anregungssignal $u_{act}$ in Form einer periodischen Wechselspannung mit einer Amplitude $A_{act}$ verwendet:

$$u_{act} = A_{act}*\sin(2*\pi*f*t),$$

wobei t die Zeit ist und das Anregungssignal $u_{act}$ mittels einer Wechselspannungsquelle 18 erzeugt wird. D.h. mit diesem Anregungssignal $u_{act}$ wird der Piezoaktor 14 betrieben. Die Schwingung des Cantilevers 1 wird durch die Wechselwirkung mit der Probe 10, insbesondere durch Van-der-Waals-Kräfte zwischen dem Cantilever 1 bzw. der Cantileverspitze 13 und der Oberfläche der Probe 10, moduliert, wobei die Modulation die Amplitude sowie die Phase betreffen kann. D.h. die so modulierte Schwingung des Cantilevers 1 hat eine Amplitude $A_c$ und eine Phase $\phi_c$, die zunächst unbekannt sind.

Zur Detektion der modulierten Schwingung des Cantilevers 1 ist im gezeigten Ausführungsbeispiel des Stands der Technik ein piezoresistives Element 2 vorgesehen, das im oder am Cantilever 1 integriert ist und dessen elektrischer Widerstand $\Delta R$ sich gemäß den modulierten Schwingungen des Cantilevers 1 (aufgrund der mit der Schwingung einhergehenden Verformung des Cantilevers 1) ändert. D.h. der elektrische Widerstand $\Delta R$ des piezoresistiven Elements 2 stellt eine Sensormessgröße SMG dar, die als Funktion der Amplitude $A_c$ und der Phase $\phi_c$ zeitlich variiert.

Das piezoresistive Element 2 wird mittels einer Brückenschaltung 6 ausgewertet, wobei die Brückenschaltung 6 mit einer Gleichspannung $U_{DC}$ versorgt ist. Die Brückenschaltung 6 umfasst einen Spannungsteiler 4 und einen weiteren Spannungsteiler 5 (jeweils angedeutet durch eine strichlierte Linie), wobei der Spannungsteiler 4 einen ersten elektrischen Widerstand R1 und einen zweiten elektrischen Widerstand R2 aufweist und wobei der weitere Spannungsteiler 5 einen dritten elektrischen Widerstand R3 und einen vierten elektrischen Widerstand R4 aufweist. Der zweite elektrische Widerstand R2 wird im gezeigten Ausführungsbeispiel durch die Summe aus einem weiteren elektrischen Widerstand R' und dem elektrischen Widerstand $\Delta R$ des piezoresistiven Elements 2 gebildet, d.h.

$$R2 = R' + \Delta R.$$

Vorzugsweise sind der erste elektrische Widerstand R1, der weitere elektrische Widerstand R', der dritte elektrische Widerstand R3 sowie der vierte elektrische Widerstand R4 gleich groß mit dem Wert R gewählt oder im Falle von einstellbaren Widerständen eingestellt, d.h.

$$R1 = R' = R3 = R4 = R.$$

Dies sei im Folgenden für das in Fig. 1 gezeigte Ausführungsbeispiel angenommen.

Die modulierte Schwingung des Cantilevers 1 führt an der Brücke zu einer zeitlich variierenden Differenzspannung $u_d$, die im gezeigten Ausführungsbeispiel von einem

Operationsverstärker 8 ausgegeben wird und folgendermaßen lautet:

$$u_d = U_{DC}*(R + \Delta R)/(2*R + \Delta R) - U_{DC}/2 = U_{DC}*(\Delta R)/(4*R + 2*\Delta R).$$

Unter Verwendung der in der Praxis üblicherweise gültigen Näherung

$$\Delta R \ll R$$

ergibt sich:

$$u_d = U_{DC}/(4*R) * \Delta R = U_{DC}/(4*R) * A_c*sin(2*\pi*f*t + \phi_c).$$

Um nun eine Demodulation durchzuführen und $A_c$ oder $\phi_c$ zu erhalten, ist gemäß dem Stand der Technik ein aufwendiger und teurer Lock-In-Verstärker 15 vorgesehen, in welchen $u_d$ eingespeist wird. In den Lock-In-Verstärker 15 wird außerdem das Anregungssignal $u_{act}$ als Referenzsignal eingespeist, wobei eine Phase $\phi_{ref}$ des Anregungssignals $u_{act}$ mittels eines Phasenschiebers 16 des Lock-In-Verstärkers 15 verschoben wird. Insbesondere kann durch den Phasenschieber 16 eine Anpassung von $\phi_{ref}$ an $\phi_c$ erreicht werden, d.h.

$$\phi_{ref} \approx \phi_c.$$

Diese Anpassung kann in an sich bekannter und automatisierter Weise durchgeführt werden, indem der Cantilever 1 zunächst ohne Probe 10 zum Schwingen angeregt wird und die Phase $\phi_{ref}$ mittels des Phasenschiebers 16 solange variiert wird, bis ein Ausgangssignal $u_{lia}$ am Ausgang des Lock-In-Verstärkers 15 maximal ist.

Das Ausgangssignal $u_{lia}$ des Lock-In-Verstärkers 15 ergibt sich folgendermaßen: Das phasenverschobene Referenzsignal wird mittels eines Multiplizierers 17 des Lock-In-Verstärkers 15 mit der Differenzspannung $u_d$ multipliziert, wobei diese Multiplikation ein multipliziertes Signal $u_m$ liefert. Das multiplizierte Signal $u_m$ wird sodann mittels eines elektronischen Tiefpassfilters 3 des Lock-In-Verstärkers 15 gefiltert und schließlich mittels eines Verstärkers 7 des Lock-Verstärkers 15 verstärkt, was schließlich das Ausgangssignal $u_{lia}$ ergibt.

Im Ausführungsbeispiel der Fig. 1 ergibt sich für das multiplizierte Signal $u_m$ grundsätzlich (unter obiger Näherung $\Delta R \ll R$, die hier und im Folgenden stets angenommen wird)

$$u_m = U_{DC}/(4*R) * A_{act}*A_c*sin(2*\pi*f*t + \phi_c)*sin(2*\pi*f*t + \phi_{ref})$$

und für den genannten Fall der angepassten Phase des Referenzsignals

$$u_m = U_{DC}/(4*R) * A_{act}*A_c*sin^2(2*\pi*f*t + \phi_c)$$

bzw. durch Umformung unter Ausnutzung der trigonometrischen Identitäten

$$u_m = U_{DC}/(8*R) * A_{act}*A_c*(1 - cos(4*\pi*f*t + 2*\phi_c)).$$

Bis auf die bekannten Faktoren $U_{DC}$, R und $A_{act}$ ergibt sich $A_c$ somit als Gleichanteil von $u_m$. Durch Anwendung des elektronischen Tiefpassfilters 3 wird der $\phi_c$ enthaltende, hochfrequente Anteil von $u_m$ abgeschnitten. Da die Verstärkung des Verstärkers 7 bekannt ist, kann daher aus dem Ausgangssignal $u_{lia}$ prinzipiell unmittelbar auf $A_c$ geschlossen werden bzw. stellt das Ausgangssignal $u_{lia}$ bis auf die genannten bekannten Faktoren die Amplitude $A_c$ der modulierten Schwingung des Cantilevers 1 dar.

Bei der AM-AFM wird der numerische Wert von $A_c$ nun typischerweise nicht per se ausgewertet, sondern es wird $u_{lia}$ mit einem Sollwert SP mittels eines Operationsverstärkers 8' verglichen, wobei der Sollwert SP in an sich bekannter und vorzugsweise automatisierter Weise bestimmt bzw. festgelegt wird. Hierzu wird die Amplitude $A_c$ bzw. $u_{lia}$ während der Annäherung des Cantilevers 2 an die Probe 10 überwacht. Wenn sich dabei der Betrag der Amplitude $A_c$ bzw. von $u_{lia}$ innerhalb einer gegeben Zeit um einen gegebenen Prozentsatz verkleinert, so wird der dann vorliegende Wert von $u_{lia}$ als Sollwert SP verwendet.

Der Operationsverstärkers 8' generiert auf diese Weise ein Kontrollsignal CS, das einer Scannersteuerung 9 zugeführt wird, die mittels des Kontrollsignals CS den (in Fig. 1 in z-Richtung gemessenen) Abstand zwischen der Probe 10 und dem Cantilever 1 bzw. der Cantileverspitze 13 justiert bzw. regelt. Ein entsprechendes Ausgabesignal OS der Scannersteuerung 9, aufgrund dessen der Scanner 11 die Bewegung der Probe 10 - grundsätzlich parallel zu allen drei Raumrichtungen x, y, z - durchführt, entspricht daher der zu bestimmenden Topographie der Probe 10.

Fig. 2 zeigt in einer Blockbilddarstellung analog zu Fig. 1 die Anwendung zweier Beispiele eines Verfahrens bei Amplituden-modulierter Rasterkraftmikroskopie, die nicht Teil der Erfindung sind, wodurch letztere wesentlich einfacher und kostengünstiger, insbesondere ohne aufwendigen und teuren Lock-In-Verstärker 15, betrieben werden kann. Wiederum wird der Cantilever 1 samt Cantileverspitze 13 mittels des Piezoaktors 14 zum Schwingen mit der Frequenz f im Bereich einer Resonanzfrequenz des Cantilevers 1 angeregt. Hierzu wird das Anregungssignal $u_{act}$ mittels der Spannungsquelle 18 erzeugt, wie oben für das bekannte Ausführungsbeispiel der Fig. 1 geschildert.

Das piezoresistive Element 2 weist wiederum den zeitlich variierenden elektrischen Widerstand $\Delta R$ als Sensormessgröße SMG auf, der gemeinsam mit dem weiteren elektrischen Widerstand R' den zweiten elektrischen Widerstand R2 des Spannungsteilers 4 der Brückenschaltung 6 ausbildet, ebenfalls wie oben geschildert.

Die Brückenschaltung 6 wird nun jedoch nicht mit der Gleichspannung $U_{DC}$ betrieben, sondern mit einem bekannten zeitlich variierenden Demodulationssignal DMS in Form einer Wechselspannung. In Fig. 2 sind zwei Varianten (in Fig. 2 mit (a) und (b) gekennzeichnet) für die Erzeugung des Demodulationssignals DMS dargestellt, zwischen denen mittels eines Schalters 19 hin und her geschaltet werden kann.

Bei Variante (a) wird als Demodulationssignal DMS das Anregungssignal $u_{act}$ der Wechselspannungsquelle 18 verwendet, sodass in diesem Fall das Demodulationssignal DMS eine lineare Funktion des Anregungssignals $u_{act}$ ist. Eine Phase $\Delta\phi$ des Demodulationssignals DMS kann dabei mittels eines dem Schalter 19 vorgeschalteten Phasenschiebers 16 eingestellt werden.

Bei Variante (b) ist eine eigene Wechselspannungsquelle 18' zur Erzeugung des Demodulationssignals DMS vorgesehen. Insbesondere kann mit der Wechselspannungsquelle 18' die Phase $\Delta\phi$ des Demodulationssignals DMS eingestellt werden. Weiters ist es natürlich auch möglich, mit der Wechselspannungsquelle 18' das Demodulationssignale DMS so zu erzeugen, dass dieses bis auf die Phase $\Delta\phi$ dem Anregungssignal $u_{act}$ entspricht.

Aufgrund der zeitlichen Änderungen von $\Delta R$ bzw. R2 wird das Demodulationssignal DMS im Spannungsteiler 4 amplitudenmoduliert, wodurch ein erstes Vergleichssignal VS1 erzeugt wird. Ein zweites Vergleichssignal VS2 wird in den Ausführungsbeispielen der Fig. 2 im weiteren Spannungsteiler 5 mittels des Demodulationssignals DMS erzeugt, wobei das zweite Vergleichssignal VS2 proportional zum Demodulationssignal DMS und somit eine lineare Funktion des Demodulationssignals DMS - und im Falle der Variante (a) auch des Anregungssignals $u_{act}$ - ist.

Die beiden Vergleichssignale VS1, VS2 werden sodann unter Verwendung der Brückenschaltung 6 voneinander abgezogen, um ein Differenzsignal DIFFS zu erzeugen, wobei sich das Differenzsignal DIFFS gewissermaßen automatisch im Brückenzweig der Brückenschaltung 6 ergibt und in den dargestellten Ausführungsbeispielen als Ausgangssignal des Operationsverstärkers 8, der im Brückenzweig der Brückenschaltung 6 angeordnet bzw. geschaltet ist, vorliegt.

Die Phase $\Delta\phi$ des Demodulationssignals DMS kann insbesondere so eingestellt werden, dass

$$\Delta\phi \approx \phi_c$$

gilt, wobei dies analog zum oben im Zusammenhang mit Fig. 1 Geschilderten geschieht. Hierzu genügt es, ohne Probe 10 die Phase $\Delta\phi$ des Demodulationssignals DMS solange, vorzugsweise automatisch, zu variieren, bis der Gleichanteil des Differenzsignals DIFFS maximal wird.

In diesem Fall ergibt sich für

$$R1 = R' = R3 = R4 = R$$

folgendes Differenzsignal DIFFS vollkommen analog zu den obigen Ausführungen betreffend das multiplizierte Signal $u_m$:

$$\text{DIFFS} = 1/(4*R) * A_{act}*A_c*\sin^2(2*\pi*f*t + \phi_c) =$$
$$1/(8*R) * A_{act}*A_c*(1 - \cos(4*\pi*f*t + 2*\phi_c)).$$

D.h. die Amplitude $A_c$ der modulierten Schwingung des Cantilevers 1 ergibt sich unmittelbar aus dem Gleichanteil des Differenzsignals DIFFS, da R und $A_{act}$ bekannt sind. In den in Fig. 2 gezeigten Ausführungsbeispielen wird durch Anwendung des elektronischen Tiefpassfilters 3 der zeitlich variierende Anteil von DIFFS abgeschnitten und das gefilterte Differenzsignal DIFFS_f erhalten, welches mit dem Verstärker 7 aus Gründen der praktischeren Handhabung verstärkt werden kann.

Es sei bemerkt, dass in vielen praktischen Anwendungsfällen kein elektronischer Tiefpassfilter 3 notwendig ist, da nachgeschaltete Elemente oftmals eine Tiefpasscharakteristik aufweisen, sodass im Wesentlichen die gleiche Wirkung wie mit dem elektronischen Tiefpassfilter 3 erzielt wird, d.h. das gefilterte Differenzsignal DIFFS_f generiert wird.

In den Beispielen der Fig. 2 wird das gefilterte Differenzsignal DIFFS_f nach dessen Verstärkung mit dem Sollwert SP mittels des Operationsverstärkers 8' verglichen, wobei der Sollwert SP in an sich bekannter und vorzugsweise automatisierter Weise bestimmt bzw. festgelegt wird, wie oben bereits im Detail zu Fig. 1 ausgeführt. Der Operationsverstärker 8' generiert auf diese Weise das Kontrollsignal CS, das der Scannersteuerung 9 zugeführt wird, die mittels des Kontrollsignals CS den (in Fig. 1 in z-Richtung gemessenen) Abstand zwischen der Probe 10 und dem Cantilever 1 bzw. der Cantileverspitze 13 justiert bzw. regelt. Das entsprechende Ausgabesignal OS der Scannersteuerung 9, aufgrund dessen der Scanner 11 die Bewegung der Probe 10 - grundsätzlich parallel zu allen drei Raumrichtungen x, y, z - durchführt, entspricht daher wiederum der zu bestimmenden Topographie der Probe 10.

In den Beispielen der Fig. 2 ist eine Steuerungseinheit 12, die zur Durchführung des erfindungsgemäßen Verfahrens eingerichtet ist, in die Scannersteuerung 9 integriert. Die Steuerungseinheit 12 ist mit der Wechselspannungsquelle 18 verbunden (angedeutet durch die punktierte Linie in Fig. 2), um diese zu steuern, womit die Steuerungseinheit 12 indirekt natürlich auch mit dem Piezoaktor 14 verbunden ist. Über die Brückenschaltung 6 und die nachgeschalteten Elemente (Operationsverstärker 8, elektronischer Tiefpassfilter 3, Verstärker 7, Operationsverstärker 8') ist die Steuerungseinheit 12 indirekt auch mit dem piezoresistiven Element 2 verbunden.

Weiters ist die elektronische Steuerungseinheit 12 bei der Variante (a) vorzugsweise mit dem Phasenschieber (16) verbunden (angedeutet durch die strichpunktierte Linie in Fig. 2), um die Phase $\Delta\phi$ des Demodulationssignals DMS einstellen zu können.

Weiters ist die elektronische Steuerungseinheit 12 bei der Variante (b) vorzugsweise mit der Wechselspannungsquelle 18' verbunden (angedeutet durch die strichpunktierte Linie mit zwei Punkten zwischen den Strichen in Fig. 2), um das Demodulationssignal DMS und insbesondere die Phase $\Delta\phi$ des Demodulationssignals DMS einstellen zu können.

Außerdem ist es denkbar, dass der Operationsverstärker 8 und/oder der elektronische Tiefpassfilter 3 und/oder der Verstärker 7 und/oder der Operationsverstärker 8' und/oder Teile der Brückenschaltung 6 - z.B. R1, R', R3 und R4 - in die Steuerungseinheit 12 integriert sein können.

Es sei betont, dass das erfindungsgemäße Verfahren z.B. auch für andere dynamische Betriebsmodi eines Rasterkraftmikroskops verwendet werden kann. In den oben beschriebenen Beispielen der Fig. 2 gilt für allgemeine Phasen $\Delta\phi$ und $\phi_c$ unter Ausnutzung der trigonometrischen Identitäten:

$$\text{DIFFS} = 1/(4*R) * A_{act}*A_c*\sin(2*\pi*f*t + \phi_c)*\sin(2*\pi*f*t + \Delta\phi) =$$

$$1/(8*R) * A_{act}*A_c*(\cos(\phi_c - \Delta\phi) - \cos(4*\pi*f*t + \phi_c + \Delta\phi)).$$

Indem nun die Phase $\Delta\phi$ des Demodulationssignals DMS so eingestellt wird, dass

$$\Delta\phi \approx \phi_c \pm \pi/2$$

gilt, wird der erste cos-Term, der konstant ist und somit den Gleichanteil von DIFFS bestimmt, zum Verschwinden gebracht. Wiederum ist eine derartige Einstellung, vorzugsweise automatisiert, möglich, indem $\Delta\phi$ variiert wird, bis der Gleichanteil von DIFFS verschwindet.

Das bedeutet aber, dass die Phase $\Delta\phi$ des Demodulationssignals DMS dazu benutzt werden kann, die Phase $\phi_c$ der modulierten Schwingung des Cantilevers 1 zu bestimmen, da mit der geschilderten Einstellung $\phi_c$ relativ zu $\pm\pi/2$ bekannt ist. Entsprechend kann mittels des erfindungsgemäßen Verfahrens auch Phasen-modulierte Rasterkraftmikroskopie (PM-AFM) oder Frequenz-modulierte Rasterkraftmikroskopie (FM-AFM) betrieben werden, welche Modi die Messung von $\phi_c$ erfordern.

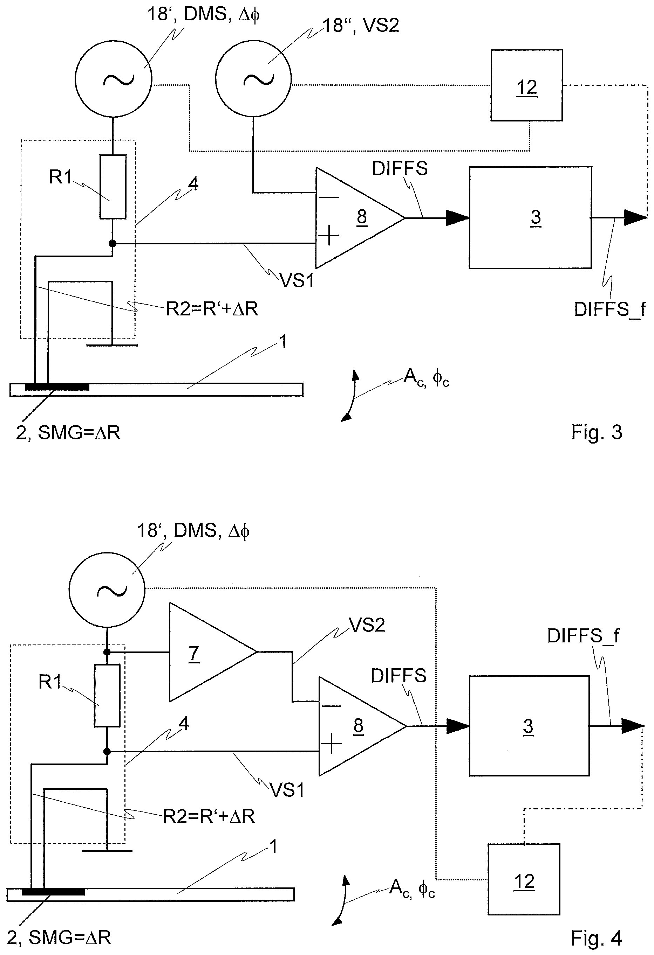

Fig. 3 zeigt beispielhaft einen Aufbau zur Durchführung eines vereinfachten Beispiels des Verfahrens, das nicht Teil der Erfindung ist, welches gemäß Fig. 3 zur Demodulation der Schwingungen eines als Cantilever 1 ausgebildeten Schwingelements Verwendung findet. Aus Klarheitsgründen sind keine Anregemittel eingezeichnet und außer dem elektronischen Tiefpassfilter 3 auch keine nachgeschalteten Elemente zur Verarbeitung des Differenzsignals DIFFS.

Beim Beispiel der Fig. 3 wird keine Brückenschaltung 6 verwendet, sondern lediglich der Spannungsteiler 4 zur Erzeugung des ersten Vergleichssignals VS1. Der Spannungsteiler 4 wird mit dem (bekannten) Demodulationssignal DMS, das mittels der Wechselspannungsquelle 18' als Wechselspannung ausgebildet ist, betrieben. Mittels der Wechselspannungsquelle 18' wird auch die Phase $\Delta\phi$ des Demodulationssignals DMS festgelegt bzw. kann die Phase $\Delta\phi$ des Demodulationssignals DMS entsprechend eingestellt werden. Da sich der zweite elektrische Widerstand R2 des Spannungsteilers 4 aus dem weiteren elektrischen Widerstand R' und dem elektrischen Widerstand $\Delta R$ des piezoresistiven Elements 2, welches im oder am Cantilever 1 integriert ist, zusammensetzt, wird die Amplitude des Demodulationssignals DMS durch die aufgrund der Schwingung des Cantilevers 1 zeitlich variierende Sensormessgröße SMG bzw. durch den zeitlich variierenden elektrischen Widerstand $\Delta R$ moduliert. Das erste Vergleichssignal VS1 wird als entsprechende Teilspannung am Spannungsteiler 4 abgegriffen und mittels des Operationsverstärkers 8 mit dem (bekannten) zweiten Vergleichssignal VS2 verglichen.

Im Beispiel der Fig. 3 wird das zweite Vergleichssignal VS2 mittels einer Wechselspannungsquelle 18" erzeugt, sodass sichergestellt ist, dass VS2 bekannt ist. Dabei kann das zweite Vergleichssignal VS2 als lineare Funktion des Demodulationssignal DMS, insbesondere gleich wie das Demodulationssignal DMS, erzeugt werden.

Die Steuerungseinheit 12 ist im Ausführungsbeispiel der Fig. 3 mit den Wechselspannungsquellen 18', 18" verbunden, um eine geeignete Erzeugung des bekannten Demodulationssignals DMS und des bekannten Vergleichssignals VS2 sicherzustellen.

Insbesondere kann dann mittels der Steuerungseinheit 12 die Phase $\Delta\phi$ des Demodulationssignals DMS so eingestellt werden, dass

$$\Delta\phi \approx \phi_c$$

gilt. Zur konkreten, vorzugsweise automatisierten, Art und Weise dieser Einstellung der Phase $\Delta\phi$ des Demodulationssignals DMS wird, wie bereits oben zur Fig. 2 geschildert, $\Delta\phi$ ohne Probe 10 solange variiert, bis der Gleichanteil von DIFFS oder ggf. von DIFFS_f maximal wird.

Wiederum ergibt sich die Amplitude $A_c$ der modulierten Schwingung des Cantilevers 1 als proportional zum Gleichanteil des Differenzsignals DIFFS. Der hochfrequente Anteil des Differenzsignals DIFFS enthält die Phase $\phi_c$ der modulierten Schwingung des Cantilevers 1. Durch Tiefpassfilterung des Differenzsignals DIFFS bleibt dessen Gleichanteil übrig, der die Phase $\phi_c$ der modulierten Schwingung des Cantilevers 1 nicht enthält. D.h. das gefilterte Differenzsignal DIFFS_f kann zur Regelung bei der Amplituden-modulierten Rasterkraftmikroskopie verwendet werden, analog zum oben beschriebenen Fall der Ausführungsformen gemäß Fig. 2.

Ebenfalls analog zu den Ausführungsbeispielen der Fig. 2 kann mittels der Steuerungseinheit 12 die Phase $\Delta\phi$ des Demodulationssignals DMS, vorzugsweise automatisiert, so eingestellt werden, dass

$$\Delta\phi \approx \phi_c \pm \pi/2$$

gilt. Hierfür wird $\Delta\phi$ variiert, bis der Gleichanteil von DIFFS verschwindet, womit außerdem $\phi_c$ relativ zu $\pm\pi/2$ unmittelbar bestimmt ist. D.h. auch das Beispiel des Verfahrens gemäß dem vereinfachten Aufbau der Fig. 3 eignet sich **u.a.** zur Verwendung bei Phasen-modulierter Rasterkraftmikroskopie oder Frequenz-modulierter Rasterkraftmikroskopie.

Die strichpunktierte Linie in Fig. 3 deutet an, dass die Steuerungseinheit 12 mit einem oder mehreren Elementen, die dem elektronischen Tiefpassfilter 3 nachgeschaltet sind, verbunden sein kann, sodass eine indirekte Verbindung zwischen der Steuerungseinheit 12 und dem piezoresistiven Element 2 gegeben ist.

Fig. 4 stellt ein Blockschaltbild eines weiteren vereinfachten Aufbaus zur Durchführung eines weiteren Beispiels des Verfahrens dar, das nicht Teil der Erfindung ist. Dieser Aufbau unterscheidet sich von jenem der Fig. 3 lediglich dadurch, dass zur Erzeugung des zweiten Vergleichssignals VS2 keine eigene Wechselspannungsquelle 18'', sondern das mittels der Wechselspannungsquelle 18' erzeugte Demodulationssignal DMS verwendet wird. Konkret wird hierzu das Demodulationssignal DMS am Eingang des Spannungsteilers 4 abgegriffen und mittels des Verstärkers 7 verstärkt, um das zweite Vergleichssignal VS2 zu erzeugen. Die Steuerungseinheit 12 ist entsprechend mit der Wechselspannungsquelle 18' verbunden, um diese geeignet ansteuern und das Demodulationssignal DMS, insbesondere dessen Phase $\Delta\phi$, wie gewünscht einstellen zu können.

Ansonsten gilt das oben zur Fig. 3 Gesagte auch für Fig. 4. D.h. die beiden Vergleichssignale VS1, VS2 werden mittels des Operationsverstärkers 8 voneinander abgezogen, um das Differenzsignal DIFFS zu erzeugen.

Sofern die Phase $\Delta\phi$ des Demodulationssignals DMS, vorzugsweise automatisiert, so eingestellt wird, dass

$$\Delta\phi \approx \phi_c$$

gilt, ist die Amplitude $A_c$ der modulierten Schwingung des Cantilevers 1 proportional zum Gleichanteil des Differenzsignals DIFFS. Der hochfrequente Anteil des Differenzsignals DIFFS enthält die Phase $\phi_c$ der modulierten Schwingung des Cantilevers 1. Durch Tiefpassfilterung des Differenzsignals DIFFS bleibt dessen Gleichanteil übrig, der die Phase $\phi_c$ der modulierten Schwingung des Cantilevers 1 nicht enthält. D.h. das gefilterte Differenzsignal DIFFS_f kann zur Regelung bei der Amplituden-modulierten Rasterkraftmikroskopie verwendet werden, analog zum oben beschriebenen Fall der Ausführungsformen gemäß Fig. 2.

Sofern die Phase $\Delta\phi$ des Demodulationssignals DMS, vorzugsweise automatisiert, so eingestellt wird, dass

$$\Delta\phi \approx \phi_c \pm \pi/2$$

gilt, wird der Gleichanteil von DIFFS zum Verschwinden gebracht und wird damit $\phi_c$ bis auf $\pm\pi/2$ bestimmt. D.h. auch die Ausführungsform des erfindungsgemäßen Verfahrens gemäß dem vereinfachten Aufbau der Fig. 4 eignet sich u.a. zur Verwendung bei Phasen-modulierter Rasterkraftmikroskopie oder Frequenz-modulierter Rasterkraftmikroskopie.

Die strichpunktierte Linie in Fig. 4 deutet an, dass die Steuerungseinheit 12 mit einem oder mehreren Elementen, die dem elektronischen Tiefpassfilter 3 nachgeschaltet sind, verbunden sein kann, sodass eine indirekte Verbindung zwischen der Steuerungseinheit 12 und dem piezoresistiven Element 2 gegeben ist.

Zu den Ausführungsbeispielen der **Fig.** 3 und der Fig. 4 sei bemerkt, dass zur Tiefpassfilterung nicht notwendigerweise ein eigener elektronischer Tiefpassfilter 3 vorgesehen sein muss, da sonstige zur Verarbeitung des Differenzsignals DIFFS nachgeschaltete Elemente eine Tiefpasscharakteristik aufweisen können. In solchen Fällen erfolgt eine Tiefpassfilterung des Differenzsignals DIFFS gewissermaßen automatisch. Beispiele für ein solches nachgeschaltetes Element wären etwa Signalanpassungselemente, die Scannersteuerung 9 (auch als Feedback-Regler bezeichnet), der Scanner 11, Anti-Aliasing-Filter oder ein Leistungsverstärker.

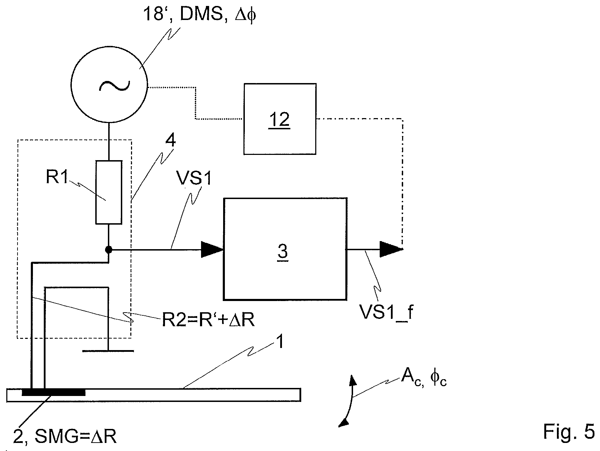

Fig. 5 zeigt beispielhaft einen minimalen Aufbau zur Durchführung eines vereinfachten bzw. "minimalen" Beispiels des Verfahrens, das nicht teil der Erfindung ist, welches gemäß Fig. 5 zur Demodulation der Schwingungen eines als Cantilever 1 ausgebildeten Schwingelements Verwendung findet. Das Verfahren, das mit dem Aufbau gemäß Fig. 5 beispielhaft verwirklicht ist, beschränkt sich im Wesentlichen auf den Kern der Erfindung, wonach bereits das erste Vergleichssignal VS1, insbesondere der Gleichanteil des ersten Vergleichssignals VS1, proportional zur Amplitude der modulierten Schwingung $A_c$ bzw. direkt abhängig von der Phase $\phi_c$ der modulierten Schwingung ist. D.h. bereits das erste Vergleichssignal VS1 liefert im Prinzip die gewünschte Information über die Amplitude $A_c$ oder Phase $\phi_c$ der modulierten Schwingung, wobei für viele Anwendungsfälle bereits die Information über das Verhältnis (statt über den exakten numerischen Wert) der zeitlich variierenden Amplitude $A_c$ der modulierten Schwingung ausreicht.

Auch in Fig. 5 sind aus Klarheitsgründen keine Anregemittel eingezeichnet und außer dem elektronischen Tiefpassfilter 3 auch keine nachgeschalteten Elemente (in diesem Fall zur Verarbeitung des ersten Vergleichssignals VS1).

Beim Beispiel der Fig. 5 wird lediglich der Spannungsteiler 4 zur Erzeugung des ersten Vergleichssignals VS1 verwendet. Der Spannungsteiler 4 wird mit dem (bekannten) Demodulationssignal DMS, das mittels der Wechselspannungsquelle 18' als Wechselspannung ausgebildet ist, betrieben. Mittels der Wechselspannungsquelle 18' wird auch die Phase $\Delta\phi$ des Demodulationssignals DMS festgelegt bzw. kann die Phase $\Delta\phi$ des Demodulationssignals DMS entsprechend eingestellt werden. Da sich der zweite elektrische Widerstand R2 des Spannungsteilers 4 aus dem weiteren elektrischen Widerstand R' und dem elektrischen Widerstand $\Delta R$ des piezoresistiven Elements 2, welches im oder am Cantilever 1 integriert ist, zusammensetzt, wird die Amplitude des Demodulationssignals DMS durch die aufgrund der Schwingung des Cantilevers 1 zeitlich variierende Sensormessgröße SMG bzw. durch den zeitlich variierenden elektrischen Widerstand $\Delta R$ moduliert. Das erste Vergleichssignal VS1 wird als entsprechende Teilspannung am Spannungsteiler 4 abgegriffen. Das erste Vergleichssignal VS1 hat einen Gleichanteil und einen zeitlich variierenden Anteil, wobei letzterer eine relativ hohe Amplitude (halbe Amplitude des Demodulationssignals DMS für R1 = R' = R) hat. Da keine Linearkombination mit einem zweiten Vergleichssignal VS2 erfolgt, wird diese Amplitude des zeitlich variierenden Anteils auch nicht weiter reduziert.

Um in diesem Fall den zeitlich variierenden Anteil mit dem Tiefpassfilter 3 entfernen und so ein gefiltertes erstes Vergleichssignal VS1_f zu erzeugen, muss der Tiefpassfilter 3 eine relativ niedrige Grenzfrequenz aufweisen, was sich wiederum auf die Geschwindigkeit des Verfahrens bzw. der Anwendungen des Verfahrens beschränkend auswirkt. D.h. beim dargestellten Ausführungsbeispiel der Fig. 5 kommt es bei der Anwendung des erfindungsgemäßen Verfahrens bei Rasterkraftmikroskopie zu einer Begrenzung der erzielbaren Scangeschwindigkeit. Insbesondere in Abhängigkeit von der zu untersuchenden Probe 10 muss dies nicht unbedingt störend sein.

Die Steuerungseinheit 12 ist im Ausführungsbeispiel der Fig. 5 mit der Wechselspannungsquelle 18' verbunden, um eine geeignete Erzeugung des bekannten Demodulationssignals DMS sicherzustellen.

Insbesondere kann dann mittels der Steuerungseinheit 12 die Phase $\Delta\phi$ des Demodulationssignals DMS so eingestellt werden, dass

$$\Delta\phi \approx \phi_c$$

gilt. Zur konkreten, vorzugsweise automatisierten, Art und Weise dieser Einstellung der Phase $\Delta\phi$ des Demodulationssignals DMS wird - analog zur obigen Schilderung im Zusammenhang mit Fig. 2 - $\Delta\phi$ ohne Probe 10 solange variiert, bis der Gleichanteil von VS1 oder ggf. von VS1_f maximal wird.

Die Amplitude $A_c$ der modulierten Schwingung des Cantilevers 1 ergibt sich als proportional zum Gleichanteil des ersten Vergleichssignals VS1. Der zeitlich variierende Anteil des ersten Vergleichssignals VS1 enthält die Phase $\phi_c$ der modulierten Schwingung des Cantilevers 1. Wie oben bereits erwähnt, bleibt durch Tiefpassfilterung des ersten Vergleichssignals VS1 dessen Gleichanteil übrig, der die Phase $\phi_c$ der modulierten Schwingung des Cantilevers 1 nicht enthält. D.h. das gefilterte erste Vergleichssignal VS1_f kann prinzipiell zur Regelung bei der Amplituden-modulierten Rasterkraftmikroskopie verwendet werden, analog zum oben beschriebenen Fall der Ausführungsformen gemäß Fig. 2.

Ebenfalls analog zu den Ausführungsbeispielen der Fig. 2 kann mittels der Steuerungseinheit 12 die Phase $\Delta\phi$ des Demodulationssignals DMS, vorzugsweise automatisiert, so eingestellt werden, dass

$$\Delta\phi \approx \phi_c \pm \pi/2$$

gilt. Hierfür wird $\Delta\phi$ variiert, bis der Gleichanteil von VS1 verschwindet, womit außerdem $\phi_c$ relativ zu $\pm\pi/2$ unmittelbar bestimmt ist. D.h. auch die Ausführungsform des erfindungsgemäßen Verfahrens gemäß dem minimalen Aufbau der Fig. 5 eignet sich u.a. zur Verwendung bei Phasen-modulierter Rasterkraftmikroskopie oder Frequenz-modulierter Rasterkraftmikroskopie.

Die strichpunktierte Linie in Fig. 5 deutet an, dass die Steuerungseinheit 12 mit einem oder mehreren Elementen, die dem elektronischen Tiefpassfilter 3 nachgeschaltet sind, verbunden sein kann, sodass eine indirekte Verbindung zwischen der Steuerungseinheit 12 und dem piezoresistiven Element 2 gegeben ist.

Abschließend sei zum Beispiel der Fig. 5 bemerkt, dass zur Tiefpassfilterung nicht notwendigerweise ein eigener elektronischer Tiefpassfilter 3 vorgesehen sein muss, da sonstige zur Verarbeitung des ersten Vergleichssignals VS1 nachgeschaltete Elemente eine geeignete Tiefpasscharakteristik aufweisen können. In solchen Fällen erfolgt eine Tiefpassfilterung des ersten Vergleichssignals VS1 gewissermaßen automatisch. Beispiele für ein solches nachgeschaltetes Element wären etwa Signalanpassungselemente, die Scannersteuerung 9 (auch als Feedback-Regler bezeichnet), der Scanner 11, Anti-Aliasing-Filter oder ein Leistungsverstärker.

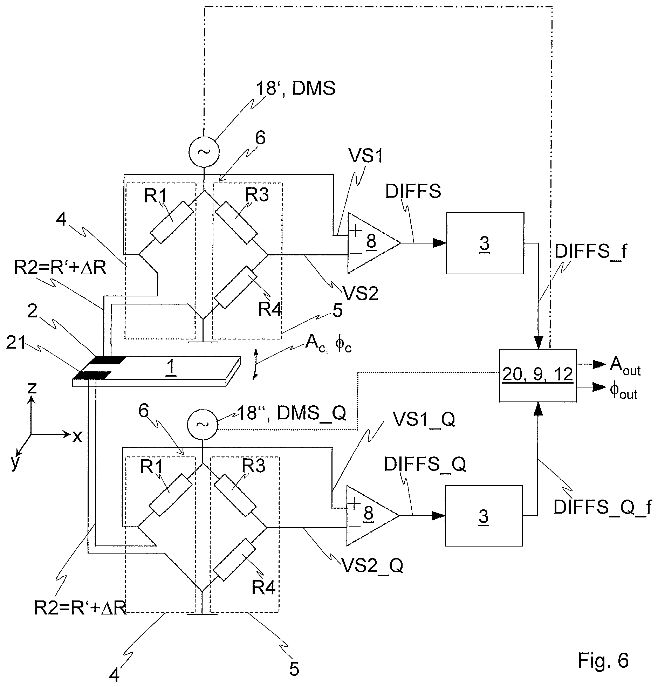

Fig. 6 zeigt in einem aus Gründen der Klarheit vereinfachten Schema (insbesondere ohne Cantileverspitze 13, Piezoaktor 14 und der Spannungsquelle zur Erzeugung des Anregungssignal $u_{act}$) die Erfindung, die die gleichzeitige Bestimmung der Amplitude $A_c$ und der Phase $\phi_c$ der modulierten Schwingung erlaubt. Hierbei sind am Schwingelement bzw. Cantilever 1 für die Detektion von dessen Schwingung das piezoresistive Element 2 sowie ein zweites piezoresistives Element 21 vorgesehen, wobei die beiden piezoresistiven Elemente 2, 21 im Wesentlichen gleich sind.

Der elektrische Widerstand $\Delta R$ des piezoresistiven Elements 2 ist wie bei den Ausführungsbeispielen der Fig. 2 Teil des zweiten elektrischen Widerstands R2 der Brückenschaltung 6, die mit dem Demodulationssignal DMS in Form einer Wechselspannung betrieben wird. Dabei wird das Demodulationssignal DMS mit Wechselspannungsquelle 18' erzeugt, wobei ansonsten das oben zur Fig. 2 Gesagte analog gilt. Entsprechend wird mittels des piezoresistiven Elements 2, der Brückenschaltung 6, dem Operationsverstärker 8 und dem Tiefpassfilter 3 das gefilterte Differenzsignal DIFFS_f erzeugt.

Das zweite piezoresistive Element 21 weist wie das piezoresistive Element 2 den gemäß der modulierten Schwingung zeitlich variierenden elektrischen Widerstand $\Delta R$ als Sensormessgröße SMG auf und ist analog zum piezoresistiven Element 2 verschaltet. D.h. der elektrische Widerstand $\Delta R$ des zweiten piezoresistiven Elements 21 bildet gemeinsam mit einem weiteren elektrischen Widerstand R' einen zweiten elektrischen Widerstand R2 eines Spannungsteilers 4 einer Brückenschaltung 6 aus. Dieser Spannungsteiler 4 weist weiters einen ersten elektrischen Widerstand R1 auf. Die Brückenschaltung 6 weist einen weiteren Spannungsteiler 5 auf, der aus einem dritten elektrischen Widerstand R3 und einem vierten elektrischen Widerstand R4 aufgebaut ist (die Spannungsteiler 4, 5 sind in Fig. 6 durch strichlierte Linien angedeutet). Diese Brückenschaltung 6 wird mit einem phasenverschobenen Demodulationssignal DMS_Q betrieben. Im dargestellten Ausführungsbeispiel ist das phasenverschobene Demodulationssignal DMS_Q bis auf einen Phasenschub von 90° ident mit dem Demodulationssignal DMS und wird mittels der Wechselspannungsquelle 18" erzeugt.

Entsprechend wird in der mit dem phasenverschobenen Demodulationssignal DMS_Q betriebenen Brückenschaltung 6 aufgrund der zeitlichen Änderungen von $\Delta R$ des zweiten piezoresistiven Elements 21 das phasenverschobene Demodulationssignal DMS_Q amplitudenmoduliert, wodurch ein erstes phasenverschobenes Vergleichssignal VS1_Q erzeugt wird, das mittels des Spannungsteilers 4 generiert und zwischen den Widerständen R1 und R2 abgegriffen wird. Ebenso wird ein zweites phasenverschobenes Vergleichssignal VS2_Q mittels des phasenverschobenen Demodulationssignals DMS_Q erzeugt, das mittels des weiteren Spannungsteilers 5 generiert und zwischen den Widerständen R3 und R4 abgegriffen wird. D.h. das zweite phasenverschobene Vergleichssignal VS2_Q ist eine lineare Funktion des phasenverschobenen Demodulationssignals DMS_Q und proportional zu diesem.

Die beiden phasenverschobenen Vergleichssignale VS1_Q, VS2_Q werden sodann unter Verwendung der Brückenschaltung 6 voneinander abgezogen, um ein phasenverschobenes Differenzsignal DIFFS_Q zu erzeugen, wobei sich das phasenverschobene Differenzsignal DIFFS_Q gewissermaßen automatisch im Brückenzweig der Brückenschaltung 6 ergibt und im dargestellten Ausführungsbeispiel als Ausgangssignal des Operationsverstärkers 8, der im Brückenzweig der Brückenschaltung 6 angeordnet bzw. geschaltet ist, vorliegt.

Diesem Operationsverstärker 8 nachgeschaltet ist ein elektronischer Tiefpassfilter 3, der entsprechend ein gefiltertes phasenverschobenes Differenzsignal DIFFS_Q_f ausgibt.

Das gefilterte phasenverschobene Differenzsignal DIFFS_Q_f und das gefilterte Differenzsignal DIFFS_f werden einer Signalverarbeitungseinheit 20, die im dargestellten Ausführungsbeispiel ebenso wie die Scannersteuerung 9 in die Steuerungseinheit 12 integriert ist, zugeführt. Die Signalverarbeitungseinheit 20 berechnet anhand der Signale DIFFS_Q_f und DIFFS_f eine Ausgabeamplitude $A_{out}$ und/oder eine Ausgabephase $\phi_{out}$.

Über die Brückenschaltungen 6 und die jeweils nachgeschalteten Elemente (Operationsverstärker 8 und elektronische Tiefpassfilter 3) ist die Steuerungseinheit 12 indirekt auch mit den piezoresistiven Elementen 2, 21 verbunden. Die strichpunktierte Linie in Fig. 6 deutet die Verbindung der Steuerungseinheit 12 mit der Wechselspannungsquelle 18' an, sodass die Steuerungseinheit 12 die Wechselspannungsquelle 18' ansteuern kann, um das Demodulationssignal DMS einzustellen. Die punktierte Linie in Fig. 6 deutet die Verbindung der Steuerungseinheit 12 mit der Wechselspannungsquelle 18" an, sodass die Steuerungseinheit 12 die Wechselspannungsquelle 18" ansteuern kann, um das phasenverschobene Demodulationssignal DMS_Q einzustellen.

Im Folgenden wird zur Illustration der Möglichkeit zur gleichzeitigen Bestimmung von $A_c$ und $\phi_c$ ein konkretes Beispiel für die Durchführung des erfindungsgemäßen Verfahrens mittels eines Aufbaus gemäß Fig. 6 beschrieben. Auch in diesem Fall wird der Cantilever 1 mittels einer sinusförmigen Wechselspannung (über einen in Fig. 6 nicht dargestellten Piezoaktor) mit der Frequenz f betrieben. Die Schwingung des Cantilevers 1 hat somit bei beiden piezoresistiven Elemente 2, 21 folgenden elektrischen Widerstand ΔR zur Folge:

$$\Delta R = A_c * \sin(2 * \pi * f * t + \phi_c).$$

Mit der Wechselspannungsquelle 18' wird folgendes Demodulationssignal DMS erzeugt:

$$DMS = A_{DMS} * \sin(2 * \pi * f * t),$$

wobei $A_{DMS}$ die Amplitude dieser Wechselspannung ist.

Mit der Wechselspannungsquelle 18" wird folgendes phasenverschobene Demodulationssignal DMS_Q erzeugt, das gegenüber dem Demodulationssignal DMS einen Phasenschub von 90° aufweist:

$$DMS\_Q = A_{DMS} * \cos(2 * \pi * f * t).$$

D.h. das phasenverschobene Demodulationssignal DMS_Q und das Demodulationssignal DMS haben dieselbe Amplitude $A_{DMS}$.

Analog zu den Ausführungen weiter oben ergibt sich für

$$R1 = R' = R3 = R4 = R$$

folgendes Differenzsignal DIFFS:

$$DIFFS \approx DMS * \Delta R / (4 * R) =$$

$$1/(4*R) * A_{DMS} * A_c * \sin(2*\pi*f*t) * \sin(2*\pi*f*t + \phi_c) =$$

$$1/(8*R) * A_{DMS} * A_c * (\cos(\phi_c) - \cos(4*\pi*f*t + \phi_c)).$$

Für das phasenverschobene Differenzsignal DIFFS_Q ergibt sich analog:

$$DIFFS\_Q \approx DMS\_Q * \Delta R / (4 * R) =$$

$$1/(4*R) * A_{DMS} * A_c * \cos(2*\pi*f*t) * \sin(2*\pi*f*t + \phi_c) =$$

$$1/(8*R) * A_{DMS} * A_c * (\sin(\phi_c) + \sin(4*\pi*f*t + \phi_c)).$$

Durch die Tiefpassfilter 3 werden die hochfrequenten Anteile entfernt, sodass das gefilterte Differenzsignal DIFFS_f und das gefilterte phasenverschobene Differenzsignal DIFFS_Q_f in Form von folgenden Gleichspannungen erhalten werden:

$$DIFFS\_f = 1/(8*R) * A_{DMS} * A_c * \cos(\phi_c)$$

und

$$DIFFS\_Q\_f = 1/(8*R) * A_{DMS} * A_c * \sin(\phi_c).$$

Diese Signale DIFFS_f und DIFFS_Q_f können in der Signalverarbeitungseinheit 20 mittels einfacher mathematischer Operationen verarbeitet werden, um die Ausgabeamplitude $A_{out}$ und die Ausgabephase $\phi_{out}$ zu bestimmen. Beispielsweise kann folgende Ausgabeamplitude $A_{out}$ berechnet werden:

$$A_{out} = ( \ (DIFFS\_f)^2 + (DIFFS\_Q\_f)^2 \ )^{1/2} =$$

$$( \ (1/(8*R) \ * \ A_{DMS}*A_c)^2 \ * \ (cos^2(\phi_c) + sin^2(\phi_c)) \ )^{1/2} =$$

$$1/(8*R) \ * \ A_{DMS}*A_c.$$

Da R und $A_{DMS}$ bekannt sind, kann aus der Ausgabeamplitude $A_{out}$ der exakte numerische Wert der Amplitude $A_c$ der modulierten Schwingung sofort bestimmt werden. Sofern es auf den exakten numerischen Wert der Amplitude $A_c$ der modulierten Schwingung nicht ankommt und ein zu $A_c$ proportionaler Wert genügt, kann die Ausgabeamplitude $A_{out}$ weiterverwendet werden. Beispielsweise kann die Ausgabeamplitude $A_{out}$ zur Einspeisung in die Scannersteuerung 9, ggf. verstärkt und/oder nach vorherigem Abgleich mit einem Sollwert SP, verwendet werden, analog wie oben bei der Beschreibung der Ausführungsbeispiele der Fig. 2 ausgeführt.

Weiters kann folgende Ausgabephase $\phi_{out}$ berechnet werden, wobei atan den Arkustangens bezeichnet und tan den Tangens:

$$\phi_{out} = atan( \ DIFFS\_Q\_f \ / \ DIFFS\_f \ ) =$$

$$atan( \ sin(\phi_c)/cos(\phi_c) \ ) =$$

$$atan( \ tan(\phi_c) \ ) = \phi_c.$$

**D.h.** diese Berechnung der Ausgabephase $\phi_{out}$ ergibt unmittelbar den exakten numerischen Wert der Phase $\phi_c$ der modulierten Schwingung.

Somit können gleichzeitig die Amplitude $A_c$ der modulierten Schwingung sowie die Phase $\phi_c$ der modulierten Schwingung bestimmt werden, ohne dass eine Anpassung der Phase des Demodulationssignals DMS wie bei den Ausführungsbeispielen der Fig. 2 notwendig wäre.

BEZUGSZEICHENLISTE

| | |
|---|---|
| 1 | Cantilever |
| 2 | Piezoresistives Element |
| 3 | Elektronischer Tiefpassfilter |
| 4 | Spannungsteiler |
| 5 | Weiterer Spannungsteiler |
| 6 | Brückenschaltung |
| 7 | Verstärker |
| 8, 8' | Operationsverstärker |
| 9 | Scannersteuerung |

| 10 | Probe |
|---|---|
| 11 | Scanner |
| 12 | Steuerungseinheit |
| 13 | Cantileverspitze |
| 14 | Piezoaktor |
| 15 | Lock-In-Verstärker |
| 16 | Phasenschieber |
| 17 | Multiplizierer |
| 18, 18', 18" | Wechselspannungsquelle |
| 19 | Schalter |
| 20 | Signalverarbeitungseinheit |
| 21 | Zweites piezoresistives Element |
| $u_{act}$ | Anregungssignal |
| $A_{act}$ | Amplitude des Anregungssignals |
| $A_c$ | Amplitude einer modulierten Schwingung |
| $A_{out}$ | Ausgabeamplitude (mit der Signalverarbeitungseinheit berechnet) |
| $\phi_c$ | Phase der modulierten Schwingung |
| $\phi_{ref}$ | Phase eines Referenzsignals |
| $\phi_{out}$ | Ausgabephase (mit der Signalverarbeitungseinheit berechnet) |
| SMG | Sensormessgröße |
| DMS | Demodulationssignal |
| $\Delta\phi$ | Phase des Demodulationssignals |
| VS1 | Erstes Vergleichssignal |
| VS1_f | Gefiltertes erstes Vergleichssignal |
| VS2 | Zweites Vergleichssignal |
| DIFFS | Differenzsignal |
| DIFFS_f | Gefiltertes Differenzsignal |
| DMS_Q | Phasenverschobenes Demodulationssignal |
| VS1_Q | Erstes phasenverschobenes Vergleichssignal |

| VS2_Q | Zweites phasenverschobenes Vergleichssignal |
|---|---|
| DIFFS_Q | Phasenverschobenes Differenzsignal |
| DIFFS_Q_f | Gefiltertes phasenverschobenes Differenzsignal |
| R1 | Erster elektrischer Widerstand |
| R2 | Zweiter elektrischer Widerstand |
| $\Delta R$ | Elektrischer Widerstand des piezoresistiven Elements bzw. des zweiten piezoresistiven Elements |
| R' | Weiterer elektrischer Widerstand |
| R3 | Dritter elektrischer Widerstand |
| R4 | Vierter elektrischer Widerstand |
| SP | Sollwert |
| CS | Kontrollsignal |
| $U_{DC}$ | Gleichspannung |
| $u_d$ | Differenzspannung |
| x, y, z | Raumrichtung |
| $u_m$ | Multipliziertes Signal |
| $u_{lia}$ | Ausgangssignal des Lock-In-Verstärkers |
| OS | Ausgabesignal |

**Patentansprüche**

1. Verfahren zur Demodulation umfassend die folgenden Schritte:

- Anregen eines schwingfähig gelagerten, zumindest abschnittsweise balkenförmig ausgebildeten Schwingelements (1) zum Schwingen im Bereich einer Resonanzfrequenz des Schwingelements (1), wobei zum Anregen ein zeitlich variierendes, insbesondere periodisches, Anregungssignal ($u_{act}$) verwendet wird und wobei zumindest die zeitliche Variation des Anregungssignals ($u_{act}$) bekannt ist oder bestimmt wird;
- Detektieren einer modulierten Schwingung des Schwingelements (1) mittels mindestens eines Sensors (2), wobei der Sensor (2) eine Sensormessgröße (SMG) liefert, die als Funktion einer Amplitude ($A_c$) und einer Phase ($\phi_c$) der modulierten Schwingung des Schwingelements (1) zeitlich variiert;
- Generieren eines ersten Vergleichssignals (VS1) durch Amplitudenmodulation eines bekannten zeitlich variierenden, insbesondere periodischen, Demodulationssignals (DMS) mittels der zeitlich variierenden Sensormessgröße (SMG),
wobei der mindestens eine Sensor ein piezoresistives Element (2) umfasst und die Sensormessgröße (SMG) der elektrische Widerstand ($\Delta R$) des piezoresistiven Elements (2) ist,
wobei das Demodulationssignal (DMS) ein Wechselspannungssignal ist und wobei das erste Vergleichssignal (VS1) mittels eines Spannungsteilers (4) generiert wird, wobei der Spannungsteiler (4) aus einem ersten elektrischen Widerstand (R1) und einem zweiten elektrischen Widerstand (R2) gebildet ist und wobei der zweite elektrische Widerstand (R2) den elektrischen Widerstand ($\Delta R$) des piezoresistiven Elements (2) umfasst,
wobei ein Differenzsignals (DIFFS) durch eine lineare Kombination des ersten Vergleichssignals (VS1) mit einem bekannten zeitlich variierenden, insbesondere periodischen, zweiten Vergleichssignal (VS2) generiert wird,
dass das Differenzsignal (DIFFS) mittels mindestens eines als Tiefpassfilter (3) wirkenden Elements gefiltert und so ein gefiltertes Differenzsignal (DIFFS_f) erzeugt wird, dass das zweite Vergleichssignal (VS2) mittels des Demodulationssignals (DMS) erzeugt wird, insbesondere indem das zweite Vergleichssignal (VS2) als lineare Funktion des Demodulationssignals (DMS) erzeugt wird, dass das zweite Vergleichssignal (VS2) mittels eines weiteren Spannungsteilers (5) generiert wird, der aus einem dritten elektrischen Widerstand (R3) und einem vierten elektrischen Widerstand (R4) gebildet ist,

wobei der Spannungsteiler (4) und der weitere Spannungsteiler (5) vorzugsweise Teil einer Brückenschaltung (6) sind,

und dass das erste Vergleichssignal (VS1) und das zweite Vergleichssignal (VS2) voneinander abgezogen werden, um das Differenzsignal (DIFFS) zu generieren,

**dadurch gekennzeichnet, dass** die modulierte Schwingung des Schwingelements (1) weiters mit einem zweiten Sensor, umfassend ein mit dem piezoresistiven Element (2) im Wesentlichen identisches zweites piezoresistives Element (21), detektiert wird, wobei der zweite Sensor ebenfalls eine Sensormessgröße (SMG) liefert, die als Funktion der Amplitude ($A_c$) und der Phase ($\phi_c$) der modulierten Schwingung des Schwingelements (1) zeitlich variiert und wobei die Sensormessgröße (SMG) des zweiten Sensors der elektrische Widerstand ($\Delta R$) des zweiten piezoresistiven Elements (21) ist,

dass ein erstes phasenverschobenes Vergleichssignal (VS1_Q) generiert wird durch Amplitudenmodulation eines bekannten zeitlich variierenden, insbesondere periodischen, phasenverschobenen Demodulationssignals (DMS_Q) mittels der zeitlich variierenden Sensormessgröße (SMG) des zweiten Sensors, wobei das phasenverschobene Demodulationssignal (DMS_Q) eine definierte bekannte Phasenverschiebung zum Demodulationssignal (DMS) aufweist, dass das phasenverschobene Demodulationssignal (DMS_Q) ebenfalls ein Wechselspannungssignal ist, wobei das erste phasenverschobene Vergleichssignal (VS1_Q) mittels eines dritten Spannungsteilers (4) generiert wird, wobei der dritte Spannungsteiler (4) aus einem fünften elektrischen Widerstand (R1) und einem sechsten elektrischen Widerstand (R2) gebildet ist und wobei der sechste elektrische Widerstand (R2) den elektrischen Widerstand ($\Delta R$) des zweiten piezoresistiven Elements (21) umfasst,

dass ein phasenverschobenes Differenzsignals (DIFFS_Q) durch eine lineare Kombination des ersten phasenverschobenen Vergleichssignals (VS1_Q) mit einem bekannten zeitlich variierenden, insbesondere periodischen, zweiten phasenverschobenen Vergleichssignal (VS2_Q) generiert wird,

dass das zweite phasenverschobene Vergleichssignal (VS2_Q) mittels des phasenverschobenen Demodulationssignals (DMS) erzeugt wird, wobei das zweite Vergleichssignal (VS2) mittels eines vierten Spannungsteilers (5) generiert wird, der aus einem siebten elektrischen Widerstand (R3) und einem achten elektrischen Widerstand (R4) gebildet ist, wobei der dritte Spannungsteiler (4) und der vierte Spannungsteiler (5) Teil einer Brückenschaltung (6) sind, und wobei das erste phasenverschobene Vergleichssignal (VS1_Q) und das zweite phasenverschobene Vergleichssignal (VS2_Q) voneinander abgezogen werden, um das phasenverschobene Differenzsignal (DIFFS_Q) zu generieren, dass das phasenverschobene Differenzsignal (DIFFS_Q) mittels mindestens eines weiteren als Tiefpassfilter (3) wirkenden Elements gefiltert und so ein gefiltertes phasenverschobenes Differenzsignal (DIFFS_Q_f) erzeugt wird.

2. Verfahren nach Anspruch 1, **dadurch gekennzeichnet, dass** das erste Vergleichssignal (VS1) mittels mindestens eines als Tiefpassfilter (3) wirkenden Elements gefiltert und so ein gefiltertes erstes Vergleichssignal (VS1_f) erzeugt wird.

3. Verfahren nach einem der Ansprüche 1 bis 2, **dadurch gekennzeichnet, dass** das Schwingelement ein Cantilever (1), insbesondere ein Cantilever (1) eines Rasterkraftmikroskops, ist.

4. Verfahren nach einem der Ansprüche 1 bis 3, **dadurch gekennzeichnet, dass** das Demodulationssignal (DMS) mittels des Anregungssignals ($u_{act}$) erzeugt wird, insbesondere indem das Demodulationssignal (DMS) als lineare Funktion des Anregungssignals ($u_{act}$) erzeugt wird.

5. Verfahren nach einem der Ansprüche 1 bis 4, **dadurch gekennzeichnet, dass** eine Phase ($\Delta\phi$) des Demodulationssignal (DMS) so verschoben wird, dass

$$\Delta\phi \approx \phi_c$$

gilt oder

$$\Delta\phi \approx \phi_c \pm \pi/2.$$

**6.** Verfahren nach einem der Ansprüche 1 bis 5 und Anspruch 3, **dadurch gekennzeichnet, dass** das gefilterte Differenzsignal (DIFFS_f) mit einem konstanten Verstärkungsfaktor verstärkt und anschließend von einem Sollwert (SP) abgezogen wird, um ein Kontrollsignal (CS) zu bilden, wobei das Kontrollsignal (CS) einer Scannersteuerung (9) zugeführt wird, um den Abstand zwischen einer Probe (10) und dem Cantilever (1) zu justieren.

**7.** Verfahren nach einem der Ansprüche 1 bis 6, **dadurch gekennzeichnet, dass** die definierte bekannte Phasenverschiebung des phasenverschobenen Demodulationssignals (DMS_Q) zum Demodulationssignal (DMS) 90° beträgt.

**8.** Verfahren nach einem der Ansprüche 1 bis 7, **dadurch gekennzeichnet, dass** das phasenverschobene Demodulationssignal (DMS_Q) mit dem Demodulationssignal (DMS) bis auf die definierte bekannte Phasenverschiebung ident ist.

**9.** Verfahren nach einem der Ansprüche 1 bis 8, **dadurch gekennzeichnet, dass** das gefilterte Differenzsignal (DIFFS_f) und das gefilterte phasenverschobene Differenzsignal (DIFFS_Q_f) mittels einer Signalverarbeitungseinheit verarbeitet werden, um eine Ausgabeamplitude ($A_{out}$) und/oder eine Ausgabephase ($\varphi_{out}$) zu berechnen.

**10.** Verfahren nach Anspruch 9 und Anspruch 8 und Anspruch 7, **dadurch gekennzeichnet, dass** die Ausgabeamplitude ($A_{out}$) berechnet wird gemäß

$$A_{out} = (\ (DIFFS\_f)^2 + (DIFFS\_Q\_f)^2\ )^{1/2}$$

und/oder die Ausgabephase ($\phi_{out}$) gemäß

$$\phi_{out} = atan(\ DIFFS\_Q\_f\ /\ DIFFS\_f\ ),$$

wobei $A_{out}$ die Ausgabeamplitude bezeichnet, DIFFS_f das gefilterte Differenzsignal, DIFFS_Q_f das gefilterte phasenverschobene Differenzsignal, $\phi_{out}$ die Ausgabephase und atan den Arkustangens.

**11.** Steuerungseinheit (12) zur Demodulation, wobei die Steuerungseinheit (12) mit mindestens einem Anregemittel für die Anregung eines schwingfähig gelagerten, zumindest abschnittsweise balkenförmig ausgebildeten Schwingelements (1) zum Schwingen verbindbar ist, wobei die Steuerungseinheit (12) mit mindestens zwei Sensoren (2) zur Detektion einer modulierten Schwingung des Schwingelements (1) verbindbar ist, wobei die Steuerungseinheit (12) zur Durchführung eines Verfahrens umfassend die Schritte

- Anregen eines schwingfähig gelagerten, zumindest abschnittsweise balkenförmig ausgebildeten Schwingelements (1) zum Schwingen im Bereich einer Resonanzfrequenz des Schwingelements (1), wobei zum Anregen ein zeitlich variierendes, insbesondere periodisches, Anregungssignal ($u_{act}$) verwendet wird und wobei zumindest die zeitliche Variation des Anregungssignals ($u_{act}$) bekannt ist oder bestimmt wird;
- Detektieren einer modulierten Schwingung des Schwingelements (1) mittels mindestens eines Sensors (2), wobei der Sensor (2) eine Sensormessgröße (SMG) liefert, die als Funktion einer Amplitude ($A_c$) und einer Phase ($\phi_c$) der modulierten Schwingung des Schwingelements (1) zeitlich variiert;
- Generieren eines ersten Vergleichssignals (VS1) durch Amplitudenmodulation eines bekannten zeitlich variierenden, insbesondere periodischen, Demodulationssignals (DMS) mittels der zeitlich variierenden Sensormessgröße (SMG),
wobei der mindestens eine Sensor ein piezoresistives Element (2) umfasst und die Sensormessgröße (SMG) der elektrische Widerstand ($\Delta R$) des piezoresistiven Elements (2) ist,
wobei das Demodulationssignal (DMS) ein Wechselspannungssignal ist und wobei das erste Vergleichssignal (VS1) mittels eines Spannungsteilers (4) generiert wird, wobei der Spannungsteiler (4) aus einem ersten elektrischen Widerstand (R1) und einem zweiten elektrischen Widerstand (R2) gebildet ist und wobei der zweite elektrische Widerstand (R2) den elektrischen Widerstand ($\Delta R$) des piezoresistiven Elements (2) umfasst, wobei ein Differenzsignals (DIFFS) durch eine lineare Kombination des ersten Vergleichssignals (VS1) mit einem bekannten zeitlich variierenden, insbesondere periodischen, zweiten Vergleichssignal (VS2) generiert wird,
wobei das Differenzsignal (DIFFS) mittels mindestens eines als Tiefpassfilter (3) wirkenden Elements gefiltert und so ein gefiltertes Differenzsignal (DIFFS_f) erzeugt wird, wobei das zweite Vergleichssignal (VS2) mittels des Demodulationssignals (DMS) erzeugt wird, insbesondere indem das zweite Vergleichssignal (VS2) als lineare Funktion des Demodulationssignals (DMS) erzeugt wird, wobei das zweite Vergleichssignal (VS2) mittels eines weiteren Spannungsteilers (5) generiert wird, der aus einem dritten elektrischen Widerstand (R3) und einem vierten elektrischen Widerstand (R4) gebildet ist,

wobei der Spannungsteiler (4) und der weitere Spannungsteiler (5) vorzugsweise Teil einer Brückenschaltung (6) sind,

und wobei das erste Vergleichssignal (VS1) und das zweite Vergleichssignal (VS2) voneinander abgezogen werden, um das Differenzsignal (DIFFS) zu generieren,

und wobei die modulierte Schwingung des Schwingelements (1) weiters mit einem zweiten Sensor, umfassend ein mit dem piezoresistiven Element (2) im Wesentlichen identisches zweites piezoresistives Element (21), detektiert wird, wobei der zweite Sensor ebenfalls eine Sensormessgröße (SMG) liefert, die als Funktion der Amplitude ($A_c$) und der Phase ($\phi_c$) der modulierten Schwingung des Schwingelements (1) zeitlich variiert und wobei die Sensormessgröße (SMG) des zweiten Sensors der elektrische Widerstand ($\Delta R$) des zweiten piezoresistiven Elements (21) ist,

wobei ein erstes phasenverschobenes Vergleichssignal (VS1_Q) generiert wird durch Amplitudenmodulation eines bekannten zeitlich variierenden, insbesondere periodischen, phasenverschobenen Demodulationssignals (DMS_Q) mittels der zeitlich variierenden Sensormessgröße (SMG) des zweiten Sensors, wobei das phasenverschobene Demodulationssignal (DMS_Q) eine definierte bekannte Phasenverschiebung zum Demodulationssignal (DMS) aufweist, wobei das phasenverschobene Demodulationssignal (DMS_Q) ebenfalls ein Wechselspannungssignal ist, wobei das erste phasenverschobene Vergleichssignal (VS1_Q) mittels eines dritten Spannungsteilers (4) generiert wird, wobei der dritte Spannungsteiler (4) aus einem fünften elektrischen Widerstand (R1) und einem sechsten elektrischen Widerstand (R2) gebildet ist und wobei der sechste elektrische Widerstand (R2) den elektrischen Widerstand ($\Delta R$) des zweiten piezoresistiven Elements (21) umfasst,

wobei ein phasenverschobenes Differenzsignals (DIFFS_Q) durch eine lineare Kombination des ersten phasenverschobenen Vergleichssignals (VS1_Q) mit einem bekannten zeitlich variierenden, insbesondere periodischen, zweiten phasenverschobenen Vergleichssignal (VS2_Q) generiert wird,

wobei das zweite phasenverschobene Vergleichssignal (VS2_Q) mittels des phasenverschobenen Demodulationssignals (DMS) erzeugt wird, wobei das zweite Vergleichssignal (VS2) mittels eines vierten Spannungsteilers (5) generiert wird, der aus einem siebten elektrischen Widerstand (R3) und einem achten elektrischen Widerstand (R4) gebildet ist, wobei der dritte Spannungsteiler (4) und der vierte Spannungsteiler (5) Teil einer Brückenschaltung (6) sind, und wobei das erste phasenverschobene Vergleichssignal (VS1_Q) und das zweite phasenverschobene Vergleichssignal (VS2_Q) voneinander abgezogen werden, um das phasenverschobene Differenzsignal (DIFFS_Q) zu generieren,

wobei das phasenverschobene Differenzsignal (DIFFS_Q) mittels mindestens eines weiteren als Tiefpassfilter (3) wirkenden Elements gefiltert und so ein gefiltertes phasenverschobenes Differenzsignal (DIFFS_Q_f) erzeugt wird,

oder zur Durchführung eines Verfahrens nach einem der Ansprüche 2 bis 10 eingerichtet ist.

12. Vorrichtung umfassend eine Steuerungseinheit (12) nach Anspruch 11, die Vorrichtung weiters umfassend das mindestens eine Anregemittel, wobei die Steuerungseinheit (12) mit dem mindestens einen Anregemittel verbunden ist, die Vorrichtung weiters umfassend mindestens zwei Sensoren (2), wobei die Steuerungseinheit (12) mit den mindestens zwei Sensoren (2) verbunden ist, und die Vorrichtung umfassend das zumindest abschnittsweise balkenförmig ausgebildete Schwingelement (1), wobei der erste Sensor ein piezoresistives Element (2) umfasst und die Sensormessgröße (SMG) der elektrische Widerstand ($\Delta R$) des piezoresistiven Elements (2) ist, wobei der Spannungsteiler (4) vorgesehen ist, um ein erstes Vergleichssignal (VS1) zu generieren, wobei der Spannungsteiler (4) aus einem ersten elektrischen Widerstand (R1) und einem zweiten elektrischen Widerstand (R2) gebildet ist und wobei der zweite elektrische Widerstand (R2) den elektrischen Widerstand ($\Delta R$) des piezoresistiven Elements (2) umfasst, wobei die Vorrichtung einen weiteren Spannungsteiler (5), der aus einem dritten elektrischen Widerstand (R3) und einem vierten elektrischen Widerstand (R4) gebildet ist, umfasst, um ein zweites Vergleichssignal (VS2) mittels des weiteren Spannungsteilers (5) zu generieren,

wobei der Spannungsteiler (4) und der weitere Spannungsteiler (5) vorzugsweise Teil einer Brückenschaltung (6) sind, wobei der zweite Sensor, umfassend ein mit dem piezoresistiven Element (2) im Wesentlichen identisches zweites piezoresistives Element (21), vorgesehen ist, dessen Sensormessgröße (SMG) der elektrische Widerstand ($\Delta R$) des zweiten piezoresistiven Elements (21) ist,

wobei ein dritter Spannungsteiler (4) vorgesehen ist, um ein erstes phasenverschobene Vergleichssignal (VS1_Q) zu generieren, wobei der dritte Spannungsteiler (4) aus einem fünften elektrischen Widerstand (R1) und einem sechsten elektrischen Widerstand (R2) gebildet ist und wobei der sechste elektrische Widerstand (R2) den elektrischen Widerstand ($\Delta R$) des zweiten piezoresistiven Elements (21) umfasst,

wobei ein vierter Spannungsteiler (5) vorgesehen ist, der aus einem siebten elektrischen Widerstand (R3) und einem achten elektrischen Widerstand (R4) gebildet ist, um ein zweites phasenverschobene Vergleichssignal (VS2_Q) mittels des vierten Spannungsteilers (5) zu generieren,

wobei der dritte Spannungsteiler (4) und der vierte Spannungsteiler (5) Teil einer Brückenschaltung (6) sind und wobei Mittel (8) zur Erzeugung des Differenzsignals (DIFFS) und des phasenverschobenen Differenzsignals (DIFFS_Q) vorgesehen sind,

dass ein Tiefpassfilter (3) vorgesehen ist, um durch Filterung des Differenzsignal (DIFFS) das gefilterte Differenzsignal (DIFFS_f) zu erzeugen, und ein weiterer Tiefpassfilter (3), um durch Filterung des phasenverschobenen Differenzsignals (DIFFS_Q) das gefilterte phasenverschobene Differenzsignal (DIFFS_Q_f) zu erzeugen,

und wobei eine Signalverarbeitungseinheit (20) vorgesehen ist, um das gefilterte Differenzsignal (DIFFS_f) und das gefilterte phasenverschobene Differenzsignal (DIFFS_Q_f) zu verarbeiten und eine Ausgabeamplitude ($A_{out}$) und/oder eine Ausgabephase ($\phi_{out}$) zu berechnen.

13. Vorrichtung nach Anspruch 12, **dadurch gekennzeichnet, dass** das mindestens eine Anregemittel einen Piezoaktor (14) umfasst.

14. Vorrichtung nach einem der Ansprüche 12 bis 13, **dadurch gekennzeichnet, dass** das Schwingelement ein Cantilever (1), insbesondere ein Cantilever (1) eines Rasterkraftmikroskops, ist.

**Claims**

1. Method for demodulation comprising the following steps:

• exciting a vibrationally mounted, at least sectionally bar-shaped oscillating element (1) for oscillating in the range of a resonance frequency of the oscillating element (1), wherein a temporally varying, in particular periodic, excitation signal ($u_{act}$) is used for excitation, and wherein at least the temporal variation of the excitation signal ($u_{act}$) is known or determined;

• detecting a modulated oscillation of the oscillating element (1) by means of at least one sensor (2), wherein the sensor (2) supplies a sensor measurement variable (SMG) that varies over time as a function of an amplitude ($A_c$) and a phase ($\phi_c$) of the modulated oscillation of the oscillating element (1);

• generate a first comparison signal (VS1) by amplitude modulating a known temporally varying, in particular periodic, demodulation signal (DMS) by means of the temporally varying sensor measurement variable (SMG), wherein the at least one sensor comprises a piezoresistive element (2) and the sensor measurement variable (SMG) is the electrical resistance ($\Delta R$) of the piezoresistive element (2),

wherein the demodulation signal (DMS) is an AC voltage signal and that the first comparison signal (VS1) is generated by means of a voltage divider (4), wherein the voltage divider (4) is formed from a first electrical resistance (R1) and a second electrical resistance (R2), and wherein the second electrical resistance (R2) comprises the electrical resistance ($\Delta R$) of the piezoresistive element (2),

wherein a difference signal (DIFFS) is generated by a linear combination of the first comparison signal (VS1) with a known time-varying, in particular periodic, second comparison signal (VS2),

wherein the difference signal (DIFFS) is filtered by means of at least one element acting as a low-pass filter (3) and thus generates a filtered difference signal (DIFFS_f), wherein the second comparison signal (VS2) is generated by means of the demodulation signal (DMS), in particular by generating the second comparison signal (VS2) as a linear function of the demodulation signal (DMS), wherein the second comparison signal (VS2) is generated by means of a further voltage divider (5) formed by a third electrical resistance (R3) and a fourth electrical resistance (R4), wherein the voltage divider (4) and the further voltage divider (5) are preferably part of a bridge circuit (6), wherein the first comparison signal (VS1) and the second comparison signal (VS2) are subtracted from one another to generate the difference signal (DIFFS),

**characterized in that**

the modulated oscillation of the oscillating element (1) is additionally detected with a second sensor, comprising a second piezoresistive element (21) essentially identical to the piezoresistive element (2), wherein the second sensor also supplies a sensor measurement variable (SMG) that varies versus time as a function of the amplitude ($A_c$) and the phase ($\phi_c$) of the modulated oscillation of the oscillating element (1) and wherein the sensor measurement variable (SMG) of the second sensor is the electrical resistance ($\Delta R$) of the second piezoresistive element (21),

**in that** a first phase-shifted comparison signal (VS1_Q) is generated by amplitude modulation of a known temporally varying, in particular periodic, phase-shifted demodulation signal (DMS_Q) by means of the temporally varying sensor measurement variable (SMG) of the second sensor, wherein the phase-shifted demodulation signal (DMS_Q) has a defined, known phase shift in relation to the demodulation signal (DMS),
**in that** the phase-shifted demodulation signal (DMS_Q) is also an AC voltage signal, wherein the first phase-shifted comparison signal (VS1_Q) is generated by means of a third voltage divider (4), wherein the third voltage divider (4) is formed from a fifth electrical resistance (R1) and a sixth electrical resistance (R2), and wherein the sixth electrical resistance (R2) comprises the electrical resistance (∆R) of the second piezoresistive element (21),
**in that** a phase-shifted difference signal (DIFFS_Q) is generated by a linear combination of the first phase-shifted comparison signal (VS1_Q) with a known temporally varying, in particular periodic, second phase-shifted comparison signal (VS2_Q),
**in that** the second phase-shifted comparison signal (VS2_Q) is generated by means of the phase-shifted demodulation signal (DMS), wherein the second comparison signal (VS2) is generated by means of a fourth voltage divider (5), which is formed from a seventh electrical resistance (R3) and an eighth electrical resistance (R4), wherein the third voltage divider (4) and the fourth voltage divider (5) are part of a bridge circuit (6), and wherein the first phase-shifted comparison signal (VS1_Q) and the second phase-shifted comparison signal (VS2_Q) are subtracted from one another to generate the phase-shifted difference signal (DIFFS_Q),
**in that** the phase-shifted difference signal (DIFFS_Q) is filtered by means of at least one further element acting as a low-pass filter (3), thus generating a filtered phase-shifted difference signal (DIFFS_Q_f).

2. Method according to Claim 1, **characterized in that** the first comparison signal (VS1) is filtered by means of at least one element acting as a low-pass filter (3), thus generating a filtered first comparison signal (VS1_f).

3. Method according to any one of Claims 1 to 2, **characterized in that** the oscillating element is a cantilever (1), in particular a cantilever (1) of an atomic force microscope.

4. Method according to any one of Claims 1 to 3, **characterized in that** the demodulation signal (DMS) is generated by means of the excitation signal ($u_{act}$), in particular by generating the demodulation signal (DMS) as a linear function of the excitation signal ($u_{act}$).

5. Method according to any one of Claims 1 to 4, **characterized in that** a phase ($\Delta\phi$) of the demodulation signal (DMS) is shifted such that

$$\Delta\phi \approx \phi_c$$

applies or

$$\Delta\phi \approx \phi_c \pm \pi/2.$$

6. Method according to any one of Claims 1 to 5 and Claim 3, **characterized in that** the filtered difference signal (DIFFS_f) is amplified with a constant gain factor and then subtracted from a target value (SP) in order to form a control signal (CS), wherein the control signal (CS) is fed to a scanner control (9) in order to adjust the distance between a sample (10) and the cantilever (1)

7. Method according to any one of Claims 1 to 6, **characterized in that** the defined known phase shift of the phase-shifted demodulation signal (DMS_Q) in relation to the demodulation signal (DMS) is 90°.

8. Method according to any one of Claims 1 to 7, **characterized in that** the phase-shifted demodulation signal (DMS_Q) is identical to the demodulation signal (DMS) except for the defined known phase shift.

9. Method according to any one of Claims 1 to 8, **characterized in that** the filtered difference signal (DIFFS_f) and the filtered phase-shifted difference signal (DIFFS_Q_f) are processed by means of a signal processing unit in order to calculate an output amplitude ($A_{out}$) and/or an output phase ($\varphi_{out}$).

10. Method according to Claim 9 and Claim 8 and Claim 7, **characterized in that** the output amplitude ($A_{out}$) is calculated according to

$$A_{out} = (\ (DIFFS\_f)^2 + (DIFFS\_Q\_f)^2\ )^{1/2}$$

and/or the output phase ($\varphi_{out}$) is calculated according to

$$\phi_{out} = atan(\ DIFFS\_Q\_f\ /\ DIFFS\_f\ ),$$

wherein $A_{out}$ is the output amplitude, DIFFS_f is the filtered difference signal, DIFFS_Q_f is the filtered phase-shifted difference signal, $\phi_{out}$ is the output phase, and atan is the arc tangent.

11. Control unit (12) for demodulation, wherein the control unit (12) is connectable for oscillation to at least one excitation means for exciting a vibrationally mounted, at least sectionally bar-shaped oscillating element (1), wherein the control unit (12) can be connected to at least two sensors (2) for detecting a modulated oscillation of the oscillating element (1), wherein the control unit (12) is formed to execute a method comprising the following steps

• exciting a vibrationally mounted, at least sectionally bar-shaped oscillating element (1) for oscillating in the range of a resonance frequency of the oscillating element (1), wherein a temporally varying, in particular periodic, excitation signal ($u_{act}$) is used for excitation, and wherein at least the temporal variation of the excitation signal ($u_{act}$) is known or determined;
• detecting a modulated oscillation of the oscillating element (1) by means of at least one sensor (2), wherein the sensor (2) supplies a sensor measurement variable (SMG) that varies over time as a function of an amplitude ($A_c$) and a phase ($\phi_c$) of the modulated oscillation of the oscillating element (1);
• generating a first comparison signal (VS1) by amplitude modulating a known temporally varying, in particular periodic, demodulation signal (DMS) by means of the temporally varying sensor measurement variable (SMG), wherein the at least one sensor comprises a piezoresistive element (2) and the sensor measurement variable (SMG) is the electrical resistance ($\Delta R$) of the piezoresistive element (2),
wherein the demodulation signal (DMS) is an AC voltage signal and wherein the first comparison signal (VS1) is generated by means of a voltage divider (4), wherein the voltage divider (4) is formed from a first electrical resistance (R1) and a second electrical resistance (R2), and wherein the second electrical resistance (R2) comprises the electrical resistance ($\Delta R$) of the piezoresistive element (2),
wherein a difference signal (DIFFS) is generated by a linear combination of the first comparison signal (VS1) with a known temporally varying, in particular periodic, second comparison signal (VS2),
wherein the difference signal (DIFFS) is filtered by means of at least one element acting as a low-pass filter (3) and a filtered difference signal (DIFFS_f) is generated, wherein the second comparison signal (VS2) is generated by means of the demodulation signal (DMS), in particular by generating the second comparison signal (VS2) as a linear function of the demodulation signal (DMS), wherein the second comparison signal (VS2) is generated by means of a further voltage divider (5) formed by a third electrical resistance (R3) and a fourth electrical resistance (R4), wherein the voltage divider (4) and the further voltage divider (5) are preferably part of a bridge circuit (6), and wherein the first comparison signal (VS1) and the second comparison signal (VS2) are subtracted from one another to generate the difference signal (DIFFS),
and wherein the modulated oscillation of the oscillating element (1) is additionally detected with a second sensor, comprising a second piezoresistive element (21) essentially identical to the piezoresistive element (2), wherein the second sensor also supplies a sensor measurement variable (SMG) that varies versus time as a function of the amplitude ($A_c$) and the phase ($\phi_c$) of the modulated oscillation of the oscillating element (1) and wherein the sensor measurement variable (SMG) of the second sensor is the electrical resistance ($\Delta R$) of the second piezoresistive element (21),
wherein a first phase-shifted comparison signal (VS1_Q) is generated by amplitude modulation of a known temporally varying, in particular periodic, phase-shifted demodulation signal (DMS_Q) by means of the temporally varying sensor measurement variable (SMG) of the second sensor, wherein the phase-shifted demodulation signal (DMS_Q) has a defined, known phase shift in relation to the demodulation signal (DMS),
wherein the phase-shifted demodulation signal (DMS_Q) is also an AC voltage signal, wherein the first phase-shifted comparison signal (VS1_Q) is generated by means of a third voltage divider (4), wherein the third voltage divider (4) is formed from a fifth electrical resistance (R1) and a sixth electrical resistance (R2), and wherein the sixth electrical resistance (R2) comprises the electrical resistance ($\Delta R$) of the second piezoresistive element (21),
wherein a phase-shifted difference signal (DIFFS_Q) is generated by a linear combination of the first phase-shifted comparison signal (VS1_Q) with a known temporally varying, in particular periodic, second phase-shifted comparison signal (VS2_Q),

wherein the second phase-shifted comparison signal (VS2_Q) is generated by means of the phase-shifted demodulation signal (DMS), wherein the second comparison signal (VS2) is generated by means of a fourth voltage divider (5), which is formed from a seventh electrical resistance (R3) and an eighth electrical resistance (R4), wherein the third voltage divider (4) and the fourth voltage divider (5) are part of a bridge circuit (6), and wherein the first phase-shifted comparison signal (VS1_Q) and the second phase-shifted comparison signal (VS2_Q) are subtracted from one another to generate the phase-shifted difference signal (DIFFS_Q),

wherein the phase-shifted difference signal (DIFFS_Q) is filtered by means of at least one further element acting as a low-pass filter (3), thus generating a filtered phase-shifted difference signal (DIFFS_Q_f),

or

a method according to any one of Claims 2 to 10.

12. Device comprising a control unit (12) according to claim 11, the device further comprising the at least one excitation means, wherein the control unit (12) is connected to the at least one excitation means, the device further comprising at least two sensors (2), wherein the control unit (12) is connected to the at least two sensors (2), and the device comprising the at least sectionally bar-shaped oscillating element (1), wherein the first sensor comprises a piezoresistive element (2) and the sensor measurement variable (SMG) is the electrical resistance ($\Delta R$) of the piezo-resistive element (2),

wherein the voltage divider (4) is provided to generate a first comparison signal (VS1), wherein the voltage divider (4) is formed from a first electrical resistance (R1) and a second electrical resistance (R2), and wherein the second electrical resistance (R2) comprises the electrical resistance ($\Delta R$) of the piezoresistive element (2),

wherein the device comprises a further voltage divider (5), which is formed from a third electrical resistance (R3) and a fourth electrical resistance (R4), in order to generate a second comparison signal (VS2) by means of the further voltage divider (5),

wherein the voltage divider (4) and the further voltage divider (5) are preferably part of a bridge circuit (6), wherein the second sensor, comprising a second piezoresistive element (21) essentially identical to the piezoresistive element (2), is provided whose sensor measurement variable (SMG) is the electrical resistance ($\Delta R$) of the second piezoresistive element (21),

wherein a third voltage divider (4) is provided to generate a first phase-shifted comparison signal (VS1_Q), wherein the third voltage divider (4) is formed from a fifth electrical resistance (R1) and a sixth electrical resistance (R2) and wherein the sixth electrical resistance (R2) comprises the electrical resistance ($\Delta R$) of the second piezoresistive element (21),

wherein a forth voltage divider (5) is provided, which is formed from a seventh electrical resistance (R3) and a eighth electrical resistance (R4) to generate a second phase-shifted comparison signal (VS2_Q) by means of the forth voltage divider (5),

wherein the third voltage divider (4) and the forth voltage divider (5) are part of a bridge circuit (6) and wherein means (8) for generating the difference signal (DIFFS) and the phase-shifted difference signal (DIFFS_Q) are provided,

in that a low-pass filter (3) is provided to generate the filtered difference signal (DIFFS_f) by filtering the difference signal (DIFFS), and a further low-pass filter (3) to generate the filtered phase-shifted difference signal (DIFFS_Q_f) by filtering the phase-shifted difference signal (DIFFS_Q),

and wherein a signal processing unit (20) is provided to process the filtered difference signal (DIFFS_f) and the filtered phase-shifted difference signal (DIFFS_Q_f) and to calculate an output amplitude ($A_{out}$) and/or an output phase ($\varphi_{out}$) .

13. The device according to claim 12, **characterized in that** the at least one excitation means comprises a piezo actuator (14).

14. The device according to any one of Claims 12 to 13, **characterized in that** the oscillating element is a cantilever (1), in particular a cantilever (1) of an atomic force microscope.

**Revendications**

1. Méthode de démodulation comprenant les étapes suivantes :

- l'excitation d'un élément oscillant (1), monté de manière apte à osciller, conçu au moins par sections en forme de barre, pour osciller dans la plage d'une fréquence de résonance de l'élément oscillant (1), un signal d'excitation

($u_{act}$) variant dans le temps, notamment périodique, étant utilisé pour l'excitation, et au moins la variation temporelle du signal d'excitation ($u_{act}$) étant connue ou étant déterminée ;

- la détection d'une oscillation modulée de l'élément oscillant (1) au moyen d'au moins un capteur (2), le capteur (2) fournissant une grandeur de mesure de capteur (SMG) qui varie dans le temps en fonction d'une amplitude ($A_c$) et d'une phase ($\phi_c$) de l'oscillation modulée de l'élément oscillant (1) ;

- la génération d'un premier signal de comparaison (VS1) par modulation d'amplitude d'un signal de démodulation (DMS) connu variant dans le temps, notamment périodique, au moyen de la grandeur de mesure de capteur (SMG) variant dans le temps,

l'au moins un capteur comprenant un élément piézorésistif (2) et la grandeur de mesure de capteur (SMG) étant la résistance électrique ($\Delta R$) de l'élément piézorésistif (2),

le signal de démodulation (DMS) étant un signal de tension alternative et le premier signal de comparaison (VS1) étant généré au moyen d'un diviseur de tension (4), le diviseur de tension (4) étant formé par une première résistance électrique (R1) et une deuxième résistance électrique (R2), et la deuxième résistance électrique (R2) comprenant la résistance électrique ($\Delta R$) de l'élément piézorésistif (2),

un signal différentiel (DIFFS) étant généré par une combinaison linéaire du premier signal de comparaison (VS1) avec un deuxième signal de comparaison (VS2) connu variant dans le temps, notamment périodique,

le signal différentiel (DIFFS) étant filtré au moyen d'au moins un élément agissant en tant que filtre passe-bas (3), et un signal différentiel filtré (DIFFS_f) étant ainsi produit,

le deuxième signal de comparaison (VS2) étant produit au moyen du signal de démodulation (DMS), notamment par le fait que le deuxième signal de comparaison (VS2) est produit en tant que fonction linéaire du signal de démodulation (DMS),

le deuxième signal de comparaison (VS2) étant généré au moyen d'un autre diviseur de tension (5), qui est formé par une troisième résistance électrique (R3) et une quatrième résistance électrique (R4), le diviseur de tension (4) et l'autre diviseur de tension (5) faisant de préférence partie d'un circuit en pont (6),

et le premier signal de comparaison (VS1) et le deuxième signal de comparaison (VS2) étant soustraits l'un de l'autre afin de générer le signal différentiel (DIFFS),

**caractérisée**

**en ce que** l'oscillation modulée de l'élément oscillant (1) est en outre détectée avec un deuxième capteur, comprenant un deuxième élément piézorésistif (21) essentiellement identique à l'élément piézorésistif (2), le deuxième capteur fournissant également une grandeur de mesure de capteur (SMG) qui varie dans le temps en fonction de l'amplitude ($A_c$) et de la phase ($\phi_c$) de l'oscillation modulée de l'élément oscillant (1), et la grandeur de mesure de capteur (SMG) du deuxième capteur étant la résistance électrique ($\Delta R$) du deuxième élément piézorésistif (21), en ce qu'un premier signal de comparaison déphasé (VS1_Q) est généré par modulation d'amplitude d'un signal de démodulation déphasé (DMS_Q) connu variant dans le temps, notamment périodique, au moyen de la grandeur de mesure de capteur (SMG) variant dans le temps du deuxième capteur, le signal de démodulation déphasé (DMS_Q) présentant un déphasage défini connu par rapport au signal de démodulation (DMS),

**en ce que** le signal de démodulation déphasé (DMS_Q) est également un signal de tension alternative, le premier signal de comparaison déphasé (VS1_Q) étant généré au moyen d'un troisième diviseur de tension (4), le troisième diviseur de tension (4) étant formé par une cinquième résistance électrique (R1) et une sixième résistance électrique (R2), et la sixième résistance électrique (R2) comprenant la résistance électrique ($\Delta R$) du deuxième élément piézorésistif (21),

**en ce qu'**un signal différentiel déphasé (DIFFS_Q) est généré par une combinaison linéaire du premier signal de comparaison déphasé (VS1_Q) avec un deuxième signal de comparaison déphasé (VS2_Q) connu variant dans le temps, notamment périodique,

**en ce que** le deuxième signal de comparaison déphasé (VS2_Q) est produit au moyen du signal de démodulation déphasé (DMS), le deuxième signal de comparaison (VS2) étant généré au moyen d'un quatrième diviseur de tension (5), qui est formé par une septième résistance électrique (R3) et une huitième résistance électrique (R4), le troisième diviseur de tension (4) et le quatrième diviseur de tension (5) faisant partie d'un circuit en pont (6), et le premier signal de comparaison déphasé (VS1_Q) et le deuxième signal de comparaison déphasé (VS2_Q) étant soustraits l'un de l'autre afin de générer le signal différentiel déphasé (DIFFS_Q),

**en ce que** le signal différentiel déphasé (DIFFS_Q) est filtré au moyen d'au moins un autre élément agissant en tant que filtre passe-bas (3), et un signal différentiel déphasé filtré (DIFFS_Q_f) est ainsi produit.

2. Méthode selon la revendication 1, **caractérisée en ce que** le premier signal de comparaison (VS1) est filtré au moyen d'au moins un élément agissant en tant que filtre passe-bas (3), et un premier signal de comparaison filtré (VS1_f) est ainsi produit.

**3.** Méthode selon l'une des revendications 1 à 2, **caractérisée en ce que** l'élément oscillant est un cantilever (1), notamment un cantilever (1) d'un microscope à force atomique.

**4.** Méthode selon l'une des revendications 1 à 3, **caractérisée en ce que** le signal de démodulation (DMS) est produit au moyen du signal d'excitation ($u_{act}$), notamment par le fait que le signal de démodulation (DMS) est produit en tant que fonction linéaire du signal d'excitation ($u_{act}$).

**5.** Méthode selon l'une des revendications 1 à 4, **caractérisée en ce qu'**une phase ($\Delta\varphi$) du signal de démodulation (DMS) est décalée de sorte que

$$\Delta\varphi \approx \varphi_c$$

ou

$$\Delta\varphi \approx \varphi_c \pm \pi/2.$$

**6.** Méthode selon l'une des revendications 1 à 5 et la revendication 3, **caractérisée en ce que** le signal différentiel filtré (DIFFS_f) est amplifié avec un facteur d'amplification constant et est ensuite soustrait d'une valeur de consigne (SP) afin de former un signal de commande (CS), le signal de commande (CS) étant transmis à un contrôleur de scanner (9) afin d'ajuster la distance entre un échantillon (10) et le cantilever (1).

**7.** Méthode selon l'une des revendications 1 à 6, **caractérisée en ce que** le déphasage défini connu du signal de démodulation déphasé (DMS_Q) par rapport au signal de démodulation (DMS) est de 90°.

**8.** Méthode selon l'une des revendications 1 à 7, **caractérisée en ce que** le signal de démodulation déphasé (DMS_Q) est identique au signal de démodulation (DMS), à l'exception du déphasage défini connu.

**9.** Méthode selon l'une des revendications 1 à 8, **caractérisée en ce que** le signal différentiel filtré (DIFFS_f) et le signal différentiel déphasé filtré (DIFFS_Q_f) sont traités au moyen d'une unité de traitement de signal afin de calculer une amplitude de sortie ($A_{out}$) et/ou une phase de sortie ($\varphi_{out}$).

**10.** Méthode selon la revendication 9 et la revendication 8 et la revendication 7, **caractérisée en ce que** l'amplitude de sortie ($A_{out}$) est calculée selon

$$A_{out} = ((DIFFS\_f)^2 + (DIFFS\_Q\_f)^2)^{1/2}$$

et/ou la phase de sortie ($\varphi_{out}$) selon

$$\varphi_{out} = atan (DIFFS\_Q\_f / DIFFS\_f),$$

$A_{out}$ désignant l'amplitude de sortie, DIFFS_f le signal différentiel filtré, DIFFS_Q_f le signal différentiel déphasé filtré, $\varphi_{out}$ la phase de sortie et atan l'arctangente.

**11.** Unité d'actionnement (12) pour la démodulation, l'unité d'actionnement (12) pouvant être reliée à au moins un moyen d'excitation pour l'excitation d'un élément oscillant (1), monté de manière apte à osciller, conçu au moins par sections en forme de barre, pour l'oscillation, l'unité d'actionnement (12) pouvant être reliée à au moins deux capteurs (2) pour la détection d'une oscillation modulée de l'élément oscillant (1), l'unité d'actionnement (12) étant adaptée pour la mise en œuvre d'un méthode comprenant les étapes suivantes

- l'excitation d'un élément oscillant (1), monté de manière apte à osciller, conçu au moins par sections en forme de barre, pour osciller dans la plage d'une fréquence de résonance de l'élément oscillant (1), un signal d'excitation ($u_{act}$) variant dans le temps, notamment périodique, étant utilisé pour l'excitation, et au moins la variation temporelle du signal d'excitation ($u_{act}$) étant connue ou étant déterminée ;
- la détection d'une oscillation modulée de l'élément oscillant (1) au moyen d'au moins un capteur (2), le capteur (2) fournissant une grandeur de mesure de capteur (SMG) qui varie dans le temps en fonction d'une amplitude ($A_c$) et d'une phase ($\phi_c$) de l'oscillation modulée de l'élément oscillant (1) ;

- la génération d'un premier signal de comparaison (VS1) par modulation d'amplitude d'un signal de démodulation (DMS) connu variant dans le temps, notamment périodique, au moyen de la grandeur de mesure de capteur (SMG) variant dans le temps,

l'au moins un capteur comprenant un élément piézorésistif (2) et la grandeur de mesure de capteur (SMG) étant la résistance électrique ($\Delta$R) de l'élément piézorésistif (2),

le signal de démodulation (DMS) étant un signal de tension alternative et le premier signal de comparaison (VS1) étant généré au moyen d'un diviseur de tension (4), le diviseur de tension (4) étant formé par une première résistance électrique (R1) et une deuxième résistance électrique (R2), et la deuxième résistance électrique (R2) comprenant la résistance électrique ($\Delta$R) de l'élément piézorésistif (2),

un signal différentiel (DIFFS) étant généré par une combinaison linéaire du premier signal de comparaison (VS1) avec un deuxième signal de comparaison (VS2) connu variant dans le temps, notamment périodique,

le signal différentiel (DIFFS) étant filtré au moyen d'au moins un élément agissant en tant que filtre passe-bas (3), et un signal différentiel filtré (DIFFS_f) étant ainsi produit,

le deuxième signal de comparaison (VS2) étant produit au moyen du signal de démodulation (DMS), notamment par le fait que le deuxième signal de comparaison (VS2) est produit en tant que fonction linéaire du signal de démodulation (DMS),

le deuxième signal de comparaison (VS2) étant généré au moyen d'un autre diviseur de tension (5), qui est formé par une troisième résistance électrique (R3) et une quatrième résistance électrique (R4), le diviseur de tension (4) et l'autre diviseur de tension (5) faisant de préférence partie d'un circuit en pont (6),

et le premier signal de comparaison (VS1) et le deuxième signal de comparaison (VS2) étant soustraits l'un de l'autre afin de générer le signal différentiel (DIFFS),

et l'oscillation modulée de l'élément oscillant (1) étant en outre détectée avec un deuxième capteur, comprenant un deuxième élément piézorésistif (21) essentiellement identique à l'élément piézorésistif (2), le deuxième capteur fournissant également une grandeur de mesure de capteur (SMG) qui varie dans le temps en fonction de l'amplitude ($A_c$) et de la phase ($\phi_c$) de l'oscillation modulée de l'élément oscillant (1), et la grandeur de mesure de capteur (SMG) du deuxième capteur étant la résistance électrique ($\Delta$R) du deuxième élément piézorésistif (21),

un premier signal de comparaison déphasé (VS1_Q) étant généré par modulation d'amplitude d'un signal de démodulation déphasé (DMS_Q) connu variant dans le temps, notamment périodique, au moyen de la grandeur de mesure de capteur (SMG) variant dans le temps du deuxième capteur, le signal de démodulation déphasé (DMS_Q) présentant un déphasage défini connu par rapport au signal de démodulation (DMS),

le signal de démodulation déphasé (DMS_Q) étant également un signal de tension alternative, le premier signal de comparaison déphasé (VS1_Q) étant généré au moyen d'un troisième diviseur de tension (4), le troisième diviseur de tension (4) étant formé par une cinquième résistance électrique (R1) et une sixième résistance électrique (R2), et la sixième résistance électrique (R2) comprenant la résistance électrique ($\Delta$R) du deuxième élément piézorésistif (21),

un signal différentiel déphasé (DIFFS_Q) étant généré par une combinaison linéaire du premier signal de comparaison déphasé (VS1_Q) avec un deuxième signal de comparaison déphasé (VS2_Q) connu variant dans le temps, notamment périodique,

le deuxième signal de comparaison déphasé (VS2_Q) étant produit au moyen du signal de démodulation déphasé (DMS), le deuxième signal de comparaison (VS2) étant généré au moyen d'un quatrième diviseur de tension (5), qui est formé par une septième résistance électrique (R3) et une huitième résistance électrique (R4), le troisième diviseur de tension (4) et le quatrième diviseur de tension (5) faisant partie d'un circuit en pont (6), et le premier signal de comparaison déphasé (VS1_Q) et le deuxième signal de comparaison déphasé (VS2_Q) étant soustraits l'un de l'autre afin de générer le signal différentiel déphasé (DIFFS_Q),

le signal différentiel déphasé (DIFFS_Q) étant filtré au moyen d'au moins un autre élément agissant en tant que filtre passe-bas (3), et un signal différentiel déphasé filtré (DIFFS_Q_f) étant ainsi produit,

ou pour la mise en œuvre d'une méthode selon l'une des revendications 2 à 10.

**12.** Dispositif comprenant une unité d'actionnement (12) selon la revendication 11, le dispositif comprenant en outre l'au moins un moyen d'excitation, l'unité d'actionnement (12) étant reliée à l'au moins un moyen d'excitation, le dispositif comprenant en outre au moins deux capteurs (2), l'unité d'actionnement (12) étant reliée aux au moins deux capteurs (2), et le dispositif comprenant l'élément oscillant (1) conçu au moins par sections en forme de barre, le premier capteur comprenant un élément piézorésistif (2) et la grandeur de mesure de capteur (SMG) étant la résistance électrique ($\Delta$R) de l'élément piézorésistif (2), le diviseur de tension (4) étant prévu afin de générer un premier signal de comparaison (VS1), le diviseur de tension (4) étant formé par une première résistance électrique (R1) et une deuxième résistance électrique (R2), et la deuxième résistance électrique (R2) comprenant la résistance électrique ($\Delta$R) de l'élément piézorésistif (2), le dispositif comprenant un autre diviseur de tension (5), formé par une troisième résistance électrique (R3) et une quatrième résistance électrique (R4), afin de générer un deuxième signal de comparaison (VS2) au moyen de l'autre diviseur de tension (5),

le diviseur de tension (4) et l'autre diviseur de tension (5) faisant de préférence partie d'un circuit en pont (6), le deuxième capteur, comprenant un deuxième élément piézorésistif (21) essentiellement identique à l'élément piézorésistif (2), dont la grandeur de mesure de capteur (SMG) est la résistance électrique ($\Delta R$) du deuxième élément piézorésistif (21), étant prévu,

un troisième diviseur de tension (4) étant prévu afin de générer un premier signal de comparaison déphasé (VS1_Q), le troisième diviseur de tension (4) étant formé par une cinquième résistance électrique (R1) et une sixième résistance électrique (R2), et la sixième résistance électrique (R2) comprenant la résistance électrique ($\Delta R$) du deuxième élément piézorésistif (21),

un quatrième diviseur de tension (5), qui est formé par une septième résistance électrique (R3) et une huitième résistance électrique (R4), étant prévu afin de générer un deuxième signal de comparaison déphasé (VS2_Q), au moyen du quatrième diviseur de tension (5),

le troisième diviseur de tension (4) et le quatrième diviseur de tension (5) faisant partie d'un circuit en pont (6), et des moyens (8) étant prévus pour produire le signal différentiel (DIFFS) et le signal différentiel déphasé (DIFFS_Q),

un filtre passe-bas (3) étant prévu afin de produire, par filtrage du signal différentiel (DIFFS), le signal différentiel filtré (DIFFS_f), et un autre filtre passe-bas (3) étant prévu afin de produire, par filtrage du signal différentiel déphasé (DIFFS_Q), le signal différentiel déphasé filtré (DIFFS_Q_f), et une unité de traitement de signal (20) étant prévue afin de traiter le signal différentiel filtré (DIFFS_f) et le signal différentiel déphasé filtré (DIFFS_Q_f) et de calculer une amplitude de sortie ($A_{out}$) et/ou une phase de sortie ($\varphi_{out}$).

13. Dispositif selon la revendication 12, **caractérisé en ce que** l'au moins un moyen d'excitation comprend un actionneur piézoélectrique (14).

14. Dispositif selon l'une des revendications 12 à 13, **caractérisé en ce que** l'élément oscillant est un cantilever (1), notamment un cantilever (1) d'un microscope à force atomique.

Fig. 1

Fig. 2

Fig. 3

Fig. 4

Fig. 5

Fig. 6

# EP 3 881 084 B1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 7462270 B2
- US 2008216583 A1
- US 5742377 A

### In der Beschreibung aufgeführte Nicht-Patentliteratur

- **RUPPERT et al.** A review of demodulation techniques for amplitude-modulation atomic force microscopy. *Beilstein Journal of Nanotechnology*, 2017, vol. 8 (1), 1407-1426
- **FISCHENEDER M. et al.** Tuneable Q-Factor of MEMS Cantilevers with Integrated Piezoelectric Thin Films. *Sensors*, 2018, vol. 18, 3842
- **CARUSO L. et al.** In Vivo Magnetic Recording of Neuronal Activity. *Neuron*, 2017, vol. 95, 1283